# EUROPEAN PATENT APPLICATION

(11) **EP 4 418 841 A2**
(43) Date of publication of application: **21.08.2024**
(21) Application number: 24152524.5
(22) Date of filing: 18.01.2024
(51) Int. Cl.: H10K 59/35, H10K 59/38, H10K 59/80

(54) **LIGHT EMITTING DISPLAY DEVICE**

(30) Priority: 20.02.2023 KR 20230022138
(71) Applicant: Samsung Display Co., Ltd., Yongin-si, Gyeonggi-do 17113 (KR)
(72) Inventor: PARK, Sung-Jae, Yongin-si (KR); KIM, Soo-Lin, Yongin-si (KR); JUN, Tae-Jong, Yongin-si (KR)
(74) Representative: Marks & Clerk LLP

(57) **Abstract**

A light emitting display device includes: a plurality of unit pixels, each including a first light emitting region, a second light emitting region, and a third light emitting region. In a unit pixel from among the plurality of unit pixels: the first light emitting region, the second light emitting region, and the third light emitting region are sequentially located along a first diagonal direction having an angle with respect to first and second directions; the first light emitting region and the second light emitting region overlap with each other in the first direction or the second direction; and the second light emitting region and the third light emitting region overlap with each other in the first direction or the second direction.

## Description

### BACKGROUND

### 1. Field

Aspects of embodiments of the present disclosure relate to a light emitting display device.

### 2. Description of Related Art

A display device is a device for displaying images, and includes a liquid crystal display (LCD), an organic light emitting diode (OLED) display, and the like. The display device is used in various electronic devices, such as a mobile phone, a navigation device, a digital camera, an electronic book, a portable game machine, and various terminals.

The organic light emitting display has a self-luminance characteristic, and unlike the liquid crystal display, a separate light source is not required, so that the thickness and weight of the organic light emitting display may be reduced. In addition, the organic light emitting display has high quality characteristics, such as low power consumption, high luminance, and fast response speeds.

The above information disclosed in this Background section is for enhancement of understanding of the background of the present disclosure, and therefore, it may contain information that does not constitute prior art.

### SUMMARY

One or more embodiments of the present disclosure are directed to a light emitting display device including an emission layer formed by using an inkjet method that may not cause color discoloration issues and/or issues with characters not being displayed clearly.

One or more embodiments of the present disclosure are directed to a light emitting display device that may secure a space suitable for laser drilling, in which a voltage is transmitted by using a laser.

According to one or more embodiments, a light emitting display device includes: a plurality of unit pixels, each including a first light emitting region, a second light emitting region, and a third light emitting region. In a unit pixel from among the plurality of unit pixels: the first light emitting region, the second light emitting region, and the third light emitting region are sequentially located along a first diagonal direction having an angle with respect to first and second directions; the first light emitting region and the second light emitting region overlap with each other in the first direction or the second direction; and the second light emitting region and the third light emitting region overlap with each other in the first direction or the second direction.

In an embodiment, the first light emitting region, the second light emitting region, and the third light emitting region may have a flat shape of a polygon including a triangle or a quadrangle. That is the light emitting regions may have polygonal shape in plan view, for example a triangle or quadrangle.

In an embodiment, at least one of edges of the polygon of the first light emitting region, the second light emitting region, and the third light emitting region may have a chamfered structure.

In an embodiment, some sides of the first light emitting region, the second light emitting region, and the third light emitting region may be parallel to the first direction or the second direction, and other sides may be parallel to or perpendicular to the first diagonal direction.

In an embodiment, the plurality of unit pixels may include first unit pixels located in a first row, and second unit pixels located in a second row directly below the first row; the first light emitting region, the second light emitting region, and the third light emitting region of the first unit pixels may be sequentially located along the first diagonal direction; and the first light emitting region, the second light emitting region, and the third light emitting region of the second unit pixels may be sequentially located along a second diagonal direction different from the first diagonal direction.

In an embodiment, the second diagonal direction may be perpendicular to the first diagonal direction.

In an embodiment, at least one of the unit pixels may further include a laser drilling region; and the second light emitting region included in the at least one of the unit pixels including the laser drilling region may be shorter than the second light emitting region of another adjacent unit pixel.

In an embodiment, the second light emitting region included in the at least one of the unit pixels including the laser drilling region may extend in a second diagonal direction perpendicular to the first diagonal direction, and may include a protruded part protruding in the first direction or the second direction.

In an embodiment, the first light emitting region, the second light emitting region, and the third light emitting region may correspond to a first opening, a second opening, and a third opening of a pixel definition layer, respectively; a first emission layer may be within the first opening, a second emission layer may be within the second opening, and a third emission layer may be within the third opening; and the first emission layer, the second emission layer, and the third emission layer may be located in the first opening, the second opening, and the third opening, respectively, by an inkjet method. In other words, the first light emitting region, the second light emitting region, and the third light emitting region may correspond to a first opening, a second opening, and a third opening of a pixel definition layer, respectively; a first emission layer may be within the first opening, a second emission layer may be within the second opening, and a third emission layer may be within the third opening; and the first emission layer, the second emission layer, and the third emission layer are inkjet printed layers.

In an embodiment, the first light emitting region, the second light emitting region, and the third light emitting region may include a red light emitting region, a green light emitting region, and a blue light emitting region, respectively.

In an embodiment, a geometric center of each planar shape of the first light emitting region, the second light emitting region, and the third light emitting region may be located along the first diagonal direction.

According to one or more embodiments of the present disclosure, a light emitting display device includes: a lower panel including a plurality of unit pixels; and an upper panel on the lower panel, and including a spacer. At least one unit pixel from among the plurality of unit pixels includes: a first light emitting region, a second light emitting region, a third light emitting region, and a laser drilling region; and the laser drilling region and the spacer overlap at least partially with each other in a plan view.

In an embodiment, the upper panel may further include: an encapsulation substrate; and a first color filter, a second color filter, and a third color filter on the encapsulation substrate. The spacer may be under the encapsulation substrate.

In an embodiment, the spacer may overlap with the first color filter, the second color filter, and the third color filter in a plan view.

In an embodiment, the first light emitting region, the second light emitting region, and the third light emitting region may be sequentially located along a first diagonal direction having an angle with respect to first and second directions; the first light emitting region and the second light emitting region may overlap with each other in the first direction or the second direction; and the second light emitting region and the third light emitting region may overlap with each other in the first direction or the second direction.

In an embodiment, the second light emitting region may extend in a second diagonal direction perpendicular to the first diagonal direction, and may include a protruded part protruding in the first direction or the second direction.

In an embodiment, the second light emitting region may have a horizontal spacing of 10 µm or more and 18 µm or less from the spacer in a plan view.

In an embodiment, the first light emitting region, the second light emitting region, and the third light emitting region may correspond to a first opening, a second opening, and a third opening of a pixel definition layer, respectively; a first emission layer may be within the first opening, a second emission layer may be within the second opening, and a third emission layer may be within the third opening; and the first light emitting region, the second light emitting region, and the third light emitting region may include a red light emitting region, a green light emitting region, and a blue light emitting region, respectively.

In an embodiment, the first light emitting region, the second light emitting region, and the third light emitting region may include a red light emitting region, a green light emitting region, and a blue light emitting region, respectively.

In an embodiment, some sides of the first light emitting region, the second light emitting region, and the third light emitting region may be parallel to the first direction or the second direction, and other sides may be parallel to or perpendicular to the first diagonal direction.

According to one or more embodiments of the present disclosure, the opening formed in the pixel definition layer may be designed to have a sufficient width for the inkjet process, so that it may be possible to form it by the inkjet process. According to one or more embodiments of the present disclosure, the opening of the pixel definition layer may be disposed in the diagonal direction to reduce a discoloration phenomenon. According to one or more embodiments of the present disclosure, the openings of the pixel definition layer may be disposed while overlapping in the diagonal direction, so that the inkjet process may be possible and the discoloration phenomenon may be reduced.

According to one or more embodiments of the present disclosure, because the light emitting regions may be arranged in the order of red, green, and blue, it may be possible to display a clear font in which the letters are neatly displayed without smearing.

According to one or more embodiments of the present disclosure, a space suitable for laser drilling may be secured by forming one small light emitting region within the unit pixel area.

At least some of the above and other features of the invention are set out in the claims.

### BRIEF DESCRIPTION OF THE DRAWINGS

The above and other aspects and features of the present disclosure will be more clearly understood from the following detailed description of the illustrative, non-limiting embodiments with reference to the accompanying drawings.
FIG. 1 and FIG. 2 are schematic top plan views of a display area of a light emitting display device according to embodiments.
FIG. 3 is a view showing characteristics of a display area according to the embodiments of FIG. 1 and FIG. 2.
FIG. 4 and FIG. 5 are schematic top plan views of a display area of a light emitting display device according to embodiments.
FIG. 6 is a view showing characteristics of a display area according to the embodiments of FIG. 4 and FIG. 5.
FIG. 7-FIG. 14 are schematic top plan views of a display area of a light emitting display device according to embodiments.
FIG. 15 is an equivalent circuit diagram of a pixel of a light emitting display device according to an embodiment.
FIG. 16-FIG. 23 are top plan views showing a manufacturing order of a display area of a light emitting display device according to an embodiment.
FIG. 24 and FIG. 25 are cross-sectional views of a light emitting display device according to embodiments.
FIG. 26 is a top plan view showing a part of a light emitting display device according to an embodiment.
FIG. 27 is a cross-sectional view of a light emitting display device according to the embodiment of FIG. 26.
FIG. 28 is a schematic top plan view of a display area of a light emitting display device according to a comparative example.
FIG. 29 is a table comparing the aperture ratios of a comparative example and an embodiment.

### DETAILED DESCRIPTION

Hereinafter, embodiments will be described in more detail with reference to the accompanying drawings, in which like reference numbers refer to like elements throughout. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described. Unless otherwise noted, like reference numerals denote like elements throughout the attached drawings and the written description, and thus, redundant description thereof may not be repeated.

When a certain embodiment may be implemented differently, a specific process order may be different from the described order. For example, two consecutively described processes may be performed at the same or substantially at the same time, or may be performed in an order opposite to the described order.

In the drawings, the relative sizes, thicknesses, and ratios of elements, layers, and regions may be exaggerated and/or simplified for clarity. Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

In the figures, the x-axis, the y-axis, and the z-axis are not limited to three axes of the rectangular coordinate system, and may be interpreted in a broader sense. For example, the x-axis, the y-axis, and the z-axis may be perpendicular to or substantially perpendicular to one another, or may represent different directions from each other that are not perpendicular to one another.

Further, as used herein, the phrases "on a plane" and "in a plan view" means when an object portion is viewed from above, and the phrases "on a cross-section" and "in a cross-sectional view) means when a cross-section taken by vertically cutting an object portion is viewed from the side.

Also, as used herein, when parts such as a wire, a layer, a film, a region, a plate, and/or a constituent element are described as being "extended in a first direction or a second direction", this includes a straight line shape extending straight or substantially straight in the corresponding direction, as well as a structure that is bent in a part, has a zigzag structure, or extends while including a curved line structure as a structure that extends overall along the first direction or the second direction.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure.

It will be understood that when an element or layer is referred to as being "on," "connected to," or "coupled to" another element or layer, it can be directly on, connected to, or coupled to the other element or layer, or one or more intervening elements or layers may be present. Similarly, when a layer, an area, or an element is referred to as being "electrically connected" to another layer, area, or element, it may be directly electrically connected to the other layer, area, or element, and/or may be indirectly electrically connected with one or more intervening layers, areas, or elements therebetween. In addition, it will also be understood that when an element or layer is referred to as being "between" two elements or layers, it can be the only element or layer between the two elements or layers, or one or more intervening elements or layers may also be present.

The terminology used herein is for the purpose of describing particular embodiments and is not intended to be limiting of the present disclosure. As used herein, the singular forms "a" and "an" are intended to include the plural forms as well, unless the context clearly indicates otherwise. It will be further understood that the terms "comprises," "comprising," "includes," "including," "has," "have," and "having," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. For example, the expression "A and/or B" denotes A, B, or A and B. Expressions such as "at least one of," when preceding a list of elements, modify the entire list of elements and do not modify the individual elements of the list. For example, the expression "at least one of a, b, or c," "at least one of a, b, and c," and "at least one selected from the group consisting of a, b, and c" indicates only a, only b, only c, both a and b, both a and c, both b and c, all of a, b, and c, or variations thereof.

As used herein, the term "substantially," "about," and similar terms are used as terms of approximation and not as terms of degree, and are intended to account for the inherent variations in measured or calculated values that would be recognized by those of ordinary skill in the art. Further, the use of "may" when describing embodiments of the present disclosure refers to "one or more embodiments of the present disclosure." As used herein, the terms "use," "using," and "used" may be considered synonymous with the terms "utilize," "utilizing," and "utilized," respectively.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

The electronic devices (e.g., a mobile phone, a TV, a monitor, a laptop computer, etc.) included in display devices and display panels described in the specification, or electronic devices included in display devices, display panels, and the like manufactured by the manufacturing methods described herein, are not excluded from the scope of the present specification.

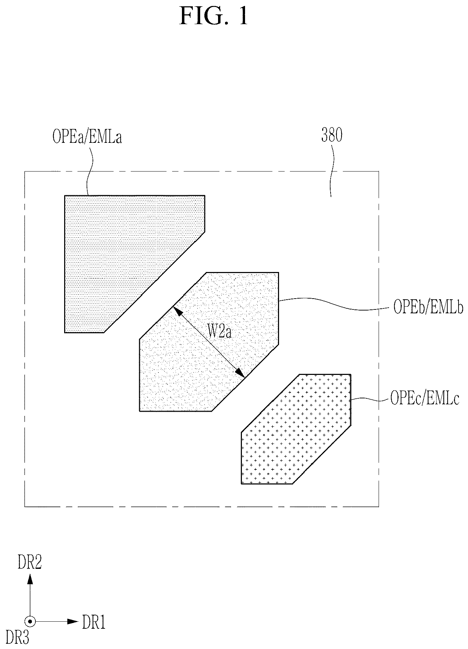

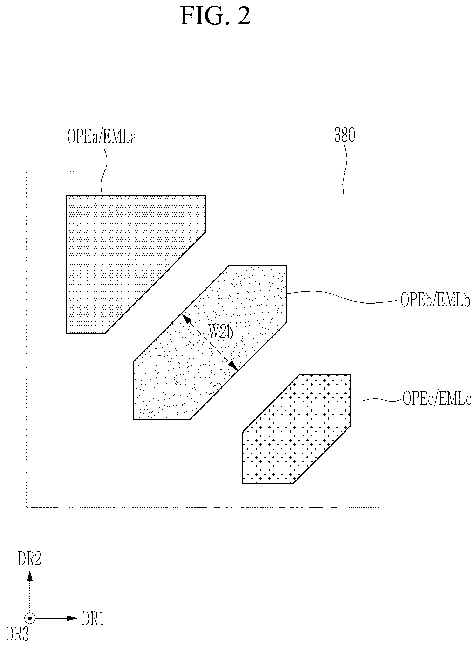

Hereinafter, various structures of a display area of a light emitting display device will be examined in more detail with reference to the figures, and first, a schematic planar structure according to various embodiments will be examined with reference to FIG. 1 and FIG. 2.

FIG. 1 and FIG. 2 are schematic top plan views of a display area of a light emitting display device according to embodiments.

The embodiment of FIG. 1 and the embodiment of FIG. 2 show planar structures of light emitting regions that are similar to each other, but different from each other. For example, the widths of a second light emitting region OPEb illustrated in FIGS. 1 and 2 are different from each other.

The embodiment illustrated in FIG. 1 is described first in more detail.

FIG. 1 shows a part of a display area, and illustrates the planar structure of one unit pixel including three light emitting regions OPEa, OPEb, and OPEc. In FIG. 1, a region (hereinafter, referred to as a unit pixel area) where one unit pixel is formed is represented by a dotted line. Each light emitting region OPEa, OPEb, and OPEc may correspond to one emission layer EMLa, EMLb, and EMLc included in a light-emitting element of a corresponding pixel. One pixel includes the light-emitting element and a pixel driver. In FIG. 1, the pixel driver is positioned under the light-emitting element, and the light emitting region OPEa, OPEb, and OPEc and/or an emission layer EMLa, EMLb, and EMLc of the light-emitting element may emit light by receiving an output current from a corresponding pixel driver. Because images are displayed by combining light of each of the light emitting regions OPEa, OPEb, and OPEc illustrated in FIG. 1, they may also be referred to as pixels, respectively. Each light emitting region OPEa, OPEb, OPEc may correspond to one opening positioned at (e.g., in or on) the pixel definition layer 380, and each emission layer EMLa, EMLb, EMLc may be positioned on the corresponding opening of the pixel definition layer 380.

In more detail, referring to FIG. 1, the first emission layer EMLa of the first light-emitting element may be positioned in the first light emitting region OPEa. The second emission layer EMLb of the second light-emitting element may be positioned in the second light emitting region OPEb. The third emission layer EMLc of the third light-emitting element may be positioned in the third light emitting region OPEc. The first light emitting region OPEa may emit red light, the second light emitting region OPEb may emit green light, and the third light emitting region OPEc may emit blue light. However, the present disclosure is not limited thereto, and the color of light emitted from each of the light emitting regions OPEa, OPEb, and OPEc may be variously modified as needed or desired.

Each light emitting region OPEa, OPEb, OPEc may be formed to have a width higher than a threshold level (e.g., a certain or predetermined level), and each emission layer EMLa, EMLb, EMLc may be formed within the corresponding opening of the pixel definition layer 380 through an inkjet process. Because the width of droplets provided by the inkjet process may have a diameter of about 55 µm according to an embodiment, the size of the opening of the pixel definition layer 380 may also be formed to have a width similar to (e.g., the same or substantially the same as) the width of the droplets.

Still referring to FIG. 1, each light emitting region OPEa, OPEb, OPEc are disposed along a first diagonal direction. At least two of the light emitting regions OPEa, OPEb, OPEc are disposed to overlap with each other in the first direction DR1 and/or second direction DR2. The first light emitting region OPEa, the second light emitting region OPEb, and the third light emitting region OPEc are sequentially disposed along the first diagonal direction. The first light emitting region OPEa and the second light emitting region OPEb are disposed to overlap with each other along the first direction DR1 or the second direction DR2, and the second light emitting region OPEb and the third light emitting region OPEc are disposed to overlap with each other along the first direction DR1 or the second direction DR2. Here, the first diagonal direction is a direction forming a suitable angle (e.g., a certain or predetermined angle) with respect to the inverse direction of the first direction DR1 and the second direction DR2. According to an embodiment, the first diagonal direction may be a direction forming an angle of 45 degrees with respect to the opposite directions of the first direction DR1 and the second direction DR2. The center of each light emitting region OPEa, OPEb, and OPEc may be disposed along the first diagonal direction. Here, the center of each light emitting region OPEa, OPEb, OPEc may refer to a geometric mass center of each light emitting region OPEa, OPEb, OPEc, and may be a position corresponding to an arithmetic average of all points included in each light emitting region OPEa, OPEb, OPEc on a plane (e.g., in a plan view).

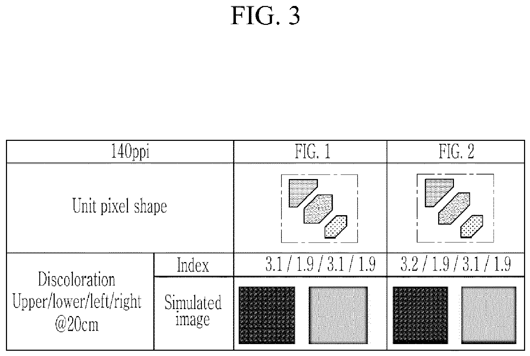

When the first light emitting region OPEa, the second light emitting region OPEb, and the third light emitting region OPEc are arranged along the first diagonal direction while overlapping with one another in the first direction DR1 and the second direction DR2 as described above, a discoloration phenomenon where a specific color may be recognized at the boundary of the displayed image may be reduced. The reduction of the discoloration phenomenon is described in more detail below with reference to FIG. 3.

As illustrated in the embodiment of FIG. 1, the first light emitting region OPEa for displaying red may be positioned on the leftmost side, the second light emitting region OPEb for displaying green may be positioned on the right thereof, and the third light emitting region OPEc for displaying blue may be positioned on the rightmost side. By arranging the light emitting regions according to the colors emitted thereby as shown in FIG. 1 based on the first direction DR1, it may be possible to display a clear font in which the letters are not smeared and are displayed neatly when the letters are displayed in a certain way. This display method may be similar to a display method of Microsoft Corporation.

In more detail, the planar shape of each light emitting region OPEa, OPEb, OPEc according to the embodiment of FIG. 1 is described as follows.

The first light emitting region OPEa according to the embodiment of FIG. 1 is positioned adjacent to two adjacently positioned sides of the unit pixel area shown as a dotted line (or dash dotted or broken line). The first light emitting region OPEa includes two sides (e.g., a first side and a second side) that are parallel to or substantially parallel to the sides of the unit pixel area extending in the first direction DR1 and the second direction DR2, respectively, and ends of the first side and the second side of the first light emitting region OPEa are in contact with each other to form a corner. The first light emitting region OPEa according to the embodiment of FIG. 1 may have a pentagon shape, and may have a structure in which two corners thereof are chamfered in a triangle shape. Some of the sides of the first light emitting region OPEa may be parallel to or substantially parallel to one side (e.g., the side extending in the first direction DR1 or the second direction DR2) of the unit pixel area shown as a dotted line, and the remaining sides (e.g., a remaining side) may be parallel to or substantially parallel to a second diagonal direction perpendicular to or substantially perpendicular to the first diagonal direction. Here, the second diagonal direction is a direction forming a suitable angle (e.g., a certain or predetermined angle) with respect to the first direction DR1 and the second direction DR2, and may be a direction forming an angle of 45 degrees with respect to the first direction DR1 and the second direction DR2 according to one or more embodiments. As shown, first light emitting region OPEa may have two lines (one long and one short) parallel to each side of the pixel unit lines and one line (an inner line) perpendiclaur tot eh first diagonal direction.

The third light emitting region OPEc according to the embodiment of FIG. 1 is positioned to be adjacent to two adjacent sides of the unit pixel area shown as a dotted line, and is positioned on opposite sides of the first diagonal direction with respect to the first light emitting region OPEa. The third light emitting region OPEc includes two sides (e.g., a first side and a second side) parallel to or substantially parallel to each side of the first direction DR1 and the second direction DR2 of the unit pixel area, and ends of the first and second sides of the third light emitting region OPEc do not touch each other, such that a side extending in the oblique direction between them is positioned. Here, the side extending in the diagonal direction may be parallel to or substantially parallel to the second diagonal direction perpendicular to or substantially perependicular to the first diagonal direction. The third light emitting region OPEc may have a hexagonal shape, and may have a structure in which three corners of a triangle shape are chamfered or two corners of a quadrangle shape are chamfered, according to an embodiment. A part of each side of the third light emitting region OPEc may be parallel to or substantially parallel to one side of the unit pixel area shown as a dotted line, and the other side may be parallel to or substantially parallel to the second diagonal direction perpendicular to or substantially perpendicular to the first diagonal direction.

The shape of the first light emitting region OPEa and the third light emitting region OPEc may be variously modified as needed or desired, but may have two sides parallel to or substantially parallel to each side of the first direction DR1 and the second direction DR2 of the unit pixel area, and may be positioned adjacent to the (sides of the) unit pixel area.

Unlike the first light emitting region OPEa and the third light emitting region OPEc, the second light emitting region OPEb according to the embodiment of FIG. 1 is positioned inside the unit pixel area and relatively farther from the sides of the unit pixel area (than the first and third light emitting regions). The center of the unit pixel area may be positioned within the second light emitting region OPEb. The second light emitting region OPEb may have a hexagonal shape, and may have a structure in which three corners of a triangle shape are chamfered or two corners of a quadrangle shape are chamfered, according to an embodiment. A part of each side of the second light emitting region OPEb may be parallel to or substantially parallel to one side of the unit pixel area shown as a dotted line, and the other side may be parallel to or substantially parallel to the second diagonal direction perpendicular to the first diagonal direction.

In the embodiment of FIG. 1, each light emitting region OPEa, OPEb, OPEc may be formed to have a suitable width (e.g., a predetermined or certain width) or more, and the emission layer may be formed by an inkjet method. For example, referring to FIG.1, the width W2a along the first diagonal direction of the second light emitting region OPEb is shown. The width W2a of the second light emitting region OPEb in the first diagonal direction may be reduced or increased as needed or desired according to embodiments. Even if the width W2a along the first diagonal direction of the second light emitting region OPEb is reduced, it may have a suitable width to the extent that the emission layer may be formed by the inkjet method.

Referring to FIG. 2, compared to the embodiment illustrated in FIG. 1, an embodiment is shown in which the width along the first diagonal direction of the second light emitting region OPEb is reduced.

From among the light emitting regions OPEa, OPEb, and OPEc according to the embodiment of FIG. 2, the first light emitting region OPEa and the third light emitting region OPEc have the same or substantially the same size and are formed of the same or substantially the same shape as those illustrated in FIG. 1. However, for the second light emitting region OPEb in the embodiment of FIG. 2, the width W2b of the first diagonal direction is shown to be formed narrower than that of the embodiment of FIG. 1.

The second light emitting region OPEb according to the embodiment of FIG. 2 may have a hexagonal shape, and may have a structure in which three corners of a triangle shape are chamfered or two corners of a quadrangle shape are chamfered, according to an embodiment. Also, a part of each side of the second light emitting region OPEb may be parallel to or substantially parallel to one side of the unit pixel area shown as a dotted line, and the other side may be parallel to or substantially parallel to the second diagonal direction perpendicular to or substantially perpendicular to the first diagonal direction. Although the second light emitting region OPEb according to the embodiment of FIG. 2 has the narrower width in the first diagonal direction than that of the embodiment of FIG. 1, it may be formed with a sufficient width to form the second emission layer by the Inkjet method.

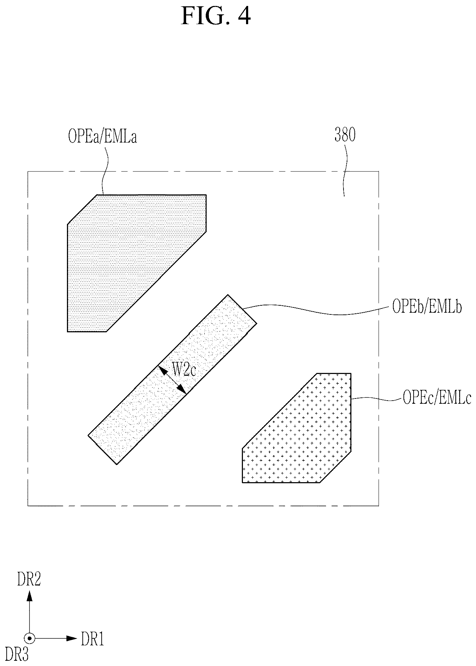

In the embodiments of FIG. 1 and FIG. 2, the first light emitting region OPEa and the third light emitting region OPEc may be formed to have the same or substantially the same shape and size as one another. However, according to an the embodiment, the sizes and shapes of each light emitting region OPEa, OPEb, and OPEc may be variously modified. Some numerous variation embodiments of each light emitting region OPEa, OPEb, OPEc are described in more detail below with reference to FIG. 4, FIG. 5, and FIG. 7 to FIG. 14.

The degree of the discoloration phenomenon that may occur in the embodiments of FIG. 1 and FIG. 2 is described in more detail hereinafter with reference to FIG. 3.

FIG. 3 is a view showing characteristics of a display area according to the embodiments of FIG. 1 and FIG. 2.

FIG. 3 simulates the degree of the discoloration of an image displayed in the display area of the embodiment of FIG. 1 and the embodiment of FIG. 2, which are formed with 140ppi, and the value thereof is displayed as a number (e.g., an index).

The discoloration phenomenon is a phenomenon in which a specific color is seen at a boundary when white or a bright color gray is displayed inside a black color background. In FIG. 3, each index is written in an order of upper/lower/left/right. The higher the value of the discoloration index, the more the discoloration, the value of 5 or less means less discoloration problems, and the value of 3.5 or less indicates a situation in which problems due to the discoloration are difficult to recognize.

In FIG. 3, for the embodiment of FIG. 1 and the embodiment of FIG. 2, although the discoloration values are relatively higher on the upper and left sides, it may be confirmed that the values thereof are lower than 3.5, such that display defects due to discoloration may not be recognized.

Also, FIG. 3 includes simulated images simulating the display area at the top of 20 cm. Two images for each of the embodiments included in FIG. 3 are illustrated. The images on the left show that each light emitting region displays a different color, and the images on the right show that each light emitting region covered in gray so that only the surrounding border is visible. In other words, the simulated images are a processed image, so that the occurrence of the discoloration phenomenon may be clearly seen.

In the embodiment of FIG. 1 and the embodiment of FIG. 2, it may be seen that some colors are recognized in the boundary area when looking at the image on the right, and it may be confirmed that the colors are recognized relatively strongly in the upper and left sides. However, because the value of the discoloration index is not large, it may not be easy for the user to actually recognize a separate color.

As described above, according to the shape, size, and arrangement of each light emitting region OPEa, OPEb, and OPEc, like those of the embodiments of FIG. 1 and/or FIG. 2, each emission layer may be formed by an inkjet method, and the discoloration phenomenon may be reduced.

Further, in the embodiments of FIG. 1 and FIG. 2, the first light emitting region OPEa for displaying red, the second light emitting region OPEb for displaying green, and the third light emitting region OPEc for displaying blue are sequentially positioned along the first direction DR1. When based on such an arrangement, it is possible to display a clear font in which letters are not smudged and displayed neatly.

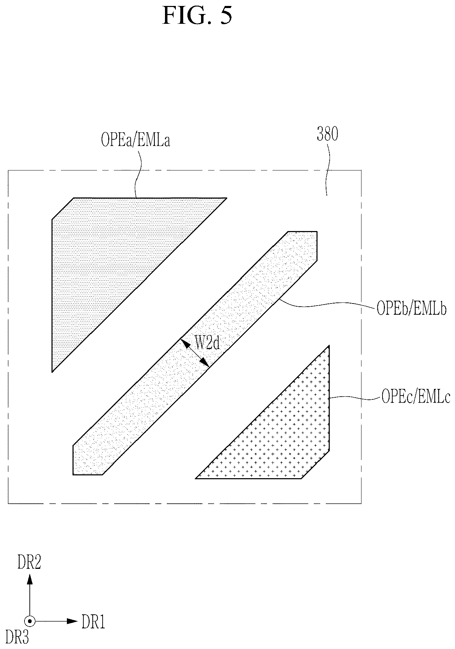

Hereinafter, the embodiments illustrated in FIG. 4 and FIG. 5 having the light emitting regions having different shapes from those of the embodiments of FIG. 1 and FIG. 2 are described in more detail.

FIG. 4 and FIG. 5 are schematic top plan views of a display area of a light emitting display device according to embodiments.

Unlike the embodiments of FIGS. 1 and 2, the embodiments of FIGS. 4 and 5 include a structure in which corners of the first light emitting region OPEa are chamfered. In the embodiment of FIG. 4, unlike the embodiment of FIG. 5, the length of the second light emitting region OPEb is shortened, and the embodiment of FIG. 4 is an embodiment that sufficiently secures a space in order to use a method (hereinafter, also referred to as a laser drilling) in which a voltage is transmitted by electrically shorting using a laser.

First, the embodiment of FIG. 4 is described in more detail hereinafter.

Referring to FIG. 4, the first light emitting region OPEa is adjacent to a side of the unit pixel area shown as a dotted line, and includes two sides (a first side and a second side) that are each parallel to or substantially parallel to a corresponding side of the first direction DR1 or the second direction DR2 of the unit pixel area. The ends of the first and second sides of the first light emitting region OPEa do not touch each other, and a side extending in the oblique direction in between them is positioned. The side extending in the oblique direction may have a second diagonal direction perpendicular to or substantially perpendicular to the first diagonal direction. The first light emitting region OPEa may have a hexagonal shape, and may have a structure in which three corners of a triangle shape are chamfered or two corners of a quadrangle shape are chamfered, according to an embodiment. A part of each outer side of the first light emitting region OPEa may be parallel to or substantially parallel to one side of the unit pixel area shown as a dotted line, and the other side (e.g., the inner side) may be parallel to or substantially parallel to the second diagonal direction perpendicular to or substantially perpendicular to the first diagonal direction. In other words, as shown, the first light emitting region OPEa may have two sides perpendicular to the first diagonal direction, two sides (one short one long) parallel to each of the sides of the unit pixel area lines.

The third light emitting region OPEc is adjacent to a side of the unit pixel area shown as a dotted line, and includes two sides (a first side and a second side) that are each parallel to or substantially parallel to a corresponding side of the first direction DR1 or the second direction DR2 of the unit pixel area. The ends of the first and second sides of the third light emitting region OPEc do not touch each other, and a side extending in the oblique direction in between them are positioned

Here, the side extending in the oblique direction may have a second diagonal direction perpendicular to or substantially perpendicular to the first diagonal direction. The third light emitting region OPEc may have a hexagonal shape, and may have a structure in which three corners of a triangle shape are chamfered or two corners of a quadrangle shape are chamfered, according to an embodiment. A part of each outer side of the third light emitting region OPEc may be parallel to or substantially parallel to one side of the unit pixel area shown as a dotted line, and the other side (e.g., the inner side) may be parallel to or substantially parallel to the second diagonal direction perpendicular to or substantially perpendicular to the first diagonal direction.

The shape of the first light emitting region OPEa and the third light emitting region OPEc may be variously modified as needed or desired, but may have two sides that are parallel to or substantially parallel to the sides of the first direction DR1 and the second direction DR2 of the unit pixel area, respectively, thereby having a shape corresponding to the pixel area.

The second light emitting region OPEb, unlike the second light emitting regions OPEb of FIG. 1 and FIG. 2, has a quadrangle shape extending in the second diagonal direction, and has a structure in which the second light emitting region OPEb is not positioned in an upper right region. The upper right region is a region for securing a space for the voltage to be transmitted by the laser drilling, and the second light emitting region OPEb is not formed because it cannot be positioned while securing the space. The second diagonal direction may be a direction that vertically crosses (e.g., intersects) the first diagonal direction. Each side of the second light emitting region OPEb may be not parallel to or substantially parallel to a side of the unit pixel area shown as a dotted line, and may be parallel to or substantially parallel to the first diagonal direction or the second diagonal direction. In other words, as shown, the second light emitting region OPEb may be a rectangle having an axis along the second diagonal direction and offset from the centre of the pixel unit towards a lower left hand side.

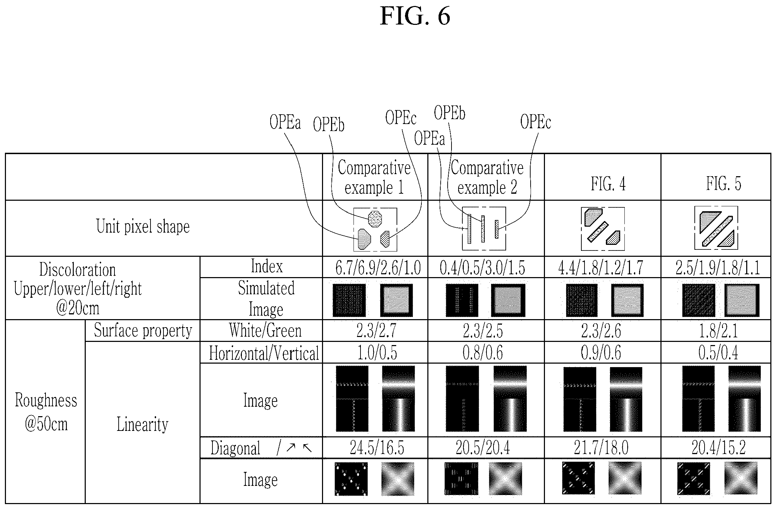

Each light emitting region OPEa, OPEb, OPEc is disposed along the first diagonal direction, and at least two of the light emitting regions OPEa, OPEb, OPEc may be disposed to overlap with each other in the first direction DR1 and/or the second direction DR2. When the center of the second light emitting region OPEb is formed without securing the laser drilling region, it may be disposed along the first diagonal direction along with the centers of the first light emitting region OPEa and the third light emitting region OPEc. When the regions are arranged along the first diagonal direction while overlapping with one another in the first direction DR1 and the second direction DR2, the discoloration phenomenon in which a specific color may be recognized at the boundary of the displayed image may be reduced. The discoloration phenomenon is described in more detail with reference to FIG. 6.

The first light emitting region OPEa for displaying red is positioned on the leftmost side, the second light emitting region OPEb for displaying green is positioned on the right thereof, and the third light emitting region OPEc for displaying blue is positioned on the rightmost side. When the colors are arranged in this way, it may be possible to display a clearer font in which the letters are not smeared and displayed neatly when the letters are displayed in a certain way. This display method may be similar to a display method of Microsoft Corporation.

Each light emitting region OPEa, OPEb, OPEc may form a corresponding emission layer EMLa, EMLb, EMLc within the corresponding opening of the pixel definition layer 380 through an inkjet process by forming the narrowest part to have a width higher than (e.g., greater than or equal to) a certain level (e.g., a threshold level). In other words, in the embodiment of FIG. 4, the width W2c of the second light emitting region OPEb is the narrowest, but even the second light emitting region OPEb having the narrow width W2c may be capable of forming the second emission layer EMLb by the Inkjet method. According to one or more embodiments, other light emitting regions OPEa and OPEc may have the narrowest width, and even the light emitting region with the narrowest width may form the emission layer by the Inkjet method.

Hereinafter, the embodiment of FIG. 5 is described in more detail.

In the embodiment of FIG. 5, unlike the embodiment of FIG. 4, the first light emitting region OPEa and the third light emitting region OPEc may have a chamfered triangle shape, and the second light emitting region OPEb may have a hexagonal shape.

Referring to FIG. 5, the first light emitting region OPEa is adjacent to a side of the unit pixel area shown as a dotted line (or dot dash line), and includes two sides (a first side and a second side) that are each parallel to or substantially parallel to a corresponding side of the first direction DR1 or the second direction DR2 of the unit pixel area. The ends of the first and second sides of the first light emitting region OPEa do not touch each other, and a side extending in the oblique direction is positioned between them. The side extending in the oblique direction may have a second diagonal direction perpendicular to or substantially perpendicular to the first diagonal direction. The first light emitting region OPEa has a chamfered triangle shape, and the chamfered corner from among a plurality of corners of the triangle may be the corner that is adjacent to a corner of the unit pixel area shown as a dotted line. According to one or more embodiments, the first light emitting region OPEa may be formed in a trapezoid shape. A part of each outer side of the first light emitting region OPEa may be parallel to or substantially parallel to one side of the unit pixel area shown as a dotted line, and the other side (e.g., the inner side) may be parallel to or substantially parallel to the second diagonal direction perpendicular to or substantially perpendicular to the first diagonal direction.

The third light emitting region OPEc is adjacent to a side of the unit pixel area shown as a dotted line, and includes two sides (a first side and a second side) that are each parallel to or substantially parallel to a corresponding of the first direction DR1 or the second direction DR2 of the unit pixel area. The ends of the first and second sides of the third light emitting region OPEc do not touch each other, and a side extending in the oblique direction is positioned between them.

The side extending in the oblique direction may have a second diagonal direction perpendicular to or substantially perpendicular to the first diagonal direction. The third light emitting region OPEc has a chamfered triangle shape, and the chamfered corner from among a plurality of corners of the triangle may be the corner that is adjacent to a corner of the unit pixel area shown as a dotted line. According to one or more embodiments, the first light emitting region OPEa may be formed in a trapezoid shape. A part of each outer side of the third light emitting region OPEc may be parallel to or substantially parallel to one side of the unit pixel area shown as a dotted line, and the other side (e.g., the inner side) may be parallel to or substantially parallel to the second diagonal direction perpendicular to or substantially perpendicular to the first diagonal direction.

The shape of the first light emitting region OPEa and the third light emitting region OPEc may be variously modified as needed or desired, but may have two sides that are parallel to or substantially parallel to the sides of the first direction DR1 and the second direction DR2 of the unit pixel area, respectively, thereby having a shape corresponding to the pixel area.

The second light emitting region OPEb, unlike the second light emitting region OPEb in FIG. 4, has a hexagonal shape that extends in the second diagonal direction, and does not include the space for the laser drilling. As such, the second light emitting region OPEb is formed over the entire region along the second diagonal direction. In this case, some of the sides of the second light emitting region OPEb may be parallel to or substantially parallel to a side of the unit pixel area shown as dotted lines, and the remaining sides may be parallel to or substantially parallel to the second diagonal direction.

Each light emitting region OPEa, OPEb, OPEc is disposed along the first diagonal direction, and at least two of the light emitting regions OPEa, OPEb, OPEc are disposed to overlap with each other in the first direction DR1 and/or the second direction DR2. The center of each light emitting region OPEa, OPEb, and OPEc may be disposed along the first diagonal direction. When the light emitting regions OPEa, OPEb, OPEc are disposed along the first diagonal direction while overlapping with one another in the first direction DR1 and the second direction DR2, the discoloration phenomenon in which a specific color may be recognized at the boundary of the displayed image may be reduced.

The first light emitting region OPEa for displaying red is positioned on the leftmost side, the second light emitting region OPEb for displaying green is positioned on the right thereof, and the third light emitting region OPEc for displaying blue is positioned on the rightmost side. When the colors are arranged in this way, it may be possible to display a clearer font in which the letters are not smeared and displayed neatly when the letters are displayed in a certain way. This display method may be similar to a display method of Microsoft Corporation.

Each light emitting region OPEa, OPEb, OPEc may form a corresponding emission layer EMLa, EMLb, EMLc within the corresponding opening of the pixel definition layer 380 through an inkjet process by forming the narrowest part to have a width higher than a certain level. In other words, in the embodiment of FIG. 5, the width W2d of the second light emitting region OPEb is the narrowest, but even the second light emitting region OPEb having the width W2d may be capable of forming the second emission layer EMLb by the Inkjet method. According to one or more embodiments, other light emitting regions OPEa and OPEc may have the narrowest width, and even the light emitting region with the narrowest width may form the emission layer by the Inkjet method.

Hereinafter, the discoloration phenomenon that may occur from the embodiments of FIG. 4 and FIG. 5 is described in more detail with reference to FIG. 6.

FIG. 6 is a view showing characteristics of a display area according to the embodiments of FIG. 4 and FIG. 5.

FIG. 6 illustrates the discoloration value (an index) of the embodiment of FIG.4 and the embodiment of FIG. 5, as well as the discoloration value (an index) of some comparative examples for comparison purposes. Also, in FIG. 6, a roughness is also indicated. Here, the roughness is a degree to which an outline is displayed ruggedly when a line or a plane is displayed, and the higher the value, the more ruggedly a straight line is displayed.

The Comparative Example 1 has a structure in which each light emitting region OPEa, OPEb, and OPEc is not arranged along the diagonal direction, but each light emitting region OPEa, OPEb, and OPEc has a certain width or more, so that the emission layer may be formed by in the inkjet method. On the other hand, the Comparative Example 2 has a stripe structure having a structure that is arranged longer in the vertical direction, so that it is an example in which the light emitting regions are not arranged along the diagonal direction, and the emission layers cannot be formed by the Inkjet method because the width is too narrow.

FIG. 6 shows the discoloration index of Comparative Example 1 and Comparative Example 2 and the embodiments of FIG. 4 and FIG. 5.

Referring to FIG. 6, in the case of Comparative Example 1, the discoloration index exceeds 5 on the upper and lower sides, and thus, the user may easily recognize the discoloration phenomenon. On the other hand, Comparative Example 2 may have a low discoloration index, but process difficulties may exist because the emission layer cannot be formed by the Inkjet method.

In comparison, the embodiments of FIG. 4 and FIG. 5 may be formed by the inkjet method, and the discoloration index also has the value of 5 or less, and thus, it may be difficult for users to recognize the discoloration phenomenon.

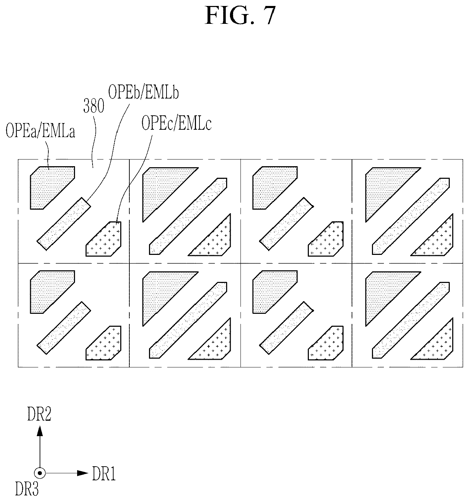

In the embodiment of FIG. 4, the discoloration index is relatively high on the upper side because the second light emitting region OPEb is not formed to extend to the upper side for the laser drilling. Because the laser drilling is not formed per unit pixel, but sparsely formed (e.g., refer to FIG. 7), even if the unit pixel of the embodiment such as that of FIG. 4 is partially included, it may be difficult for the user to easily recognize the discoloration phenomenon with respect to the entire light emitting display device.

In FIG. 6, the roughness values of Comparative Example 1 and Comparative Example 2 and the embodiments of FIG. 4 and FIG. 5 are also illustrated.

FIG. 6 also includes simulated images for the roughness, and two images are included for each of the examples. The images on the left show that each light emitting region emits light, and the images on the right show an image recognized as a straight line as it is continuously recognized by the user's eyes by each light emitting region.

In FIG. 6, a roughness value (a surface property) when displaying a surface and a roughness value (a linearity) when displaying a line are separately shown.

First, in the case of the surface property, it can be seen that the surface is shown using white and green, and all values have a value of less than 10, so it is not displayed unevenly.

On the other hand, the case of the linearity is divided into a case of displaying a straight line in the horizontal and vertical directions and a case of displaying a straight line in the diagonal direction.

In the case of displaying the linearity in the horizontal direction and the vertical direction, it can be confirmed that the roughness value is not large (e.g., less than 10), so that it is not displayed unevenly.

On the other hand, in case of displaying a straight line in the diagonal direction, the roughness value has a large value exceeding 10, and thus, it can be displayed relatively bumpy.

In the case of the diagonal direction, the roughness values are illustrated by being divided into a direction between the first direction DR1 and the second direction DR2 (e.g., ↗; corresponding to the second diagonal direction) and a direction between the opposite direction of the first direction DR1 and the second direction DR2 (e.g., ↖; corresponding to the first diagonal direction). From among the two diagonal directions, it can be seen that the roughness value of the direction (↖) corresponding to the first diagonal direction is relatively small. In more detail, when compared to Comparative Example 2, when displaying a straight line in the first diagonal direction of FIG. 4 and FIG. 5, it may be seen that the roughness value is small and then it is not displayed unevenly.

Therefore, even when displaying a straight line in the diagonal direction, it may be confirmed that the embodiments of FIG. 4 and FIG. 5 may clearly display a straight line compared to the Comparative Examples 1 and 2.

Hereinafter, other modified embodiments are described in more detail with reference to FIG. 7 to FIG. 14.

FIG. 7 through FIG. 14 are schematic top plan views of a display area of a light emitting display device according to embodiments.

First, referring to the embodiment of FIG. 7, an embodiment in which the embodiments of FIG. 4 and the embodiments of FIG. 5 are disposed together is shown. In other words, in the embodiment of FIG. 7, even in the light emitting display device that transmits a voltage by the laser drilling, it may only be necessary to secure the space for the laser drilling in some of the unit pixels, and thus, there may be no need to reserve the space for the laser drilling for every unit pixel. In the embodiment of FIG. 7, the number of the unit pixels including the laser drilling region like that of FIG. 4 and the number of the unit pixels like that of FIG. 5 are the same as each other. However, the number of the unit pixels including the laser drilling region may be relatively smaller, and it may be disposed one by one for every of a plurality of unit pixels. The arrangement of the unit pixels including the laser drilling region may be formed in various suitable positions and numbers different from that illustrated in FIG. 7.

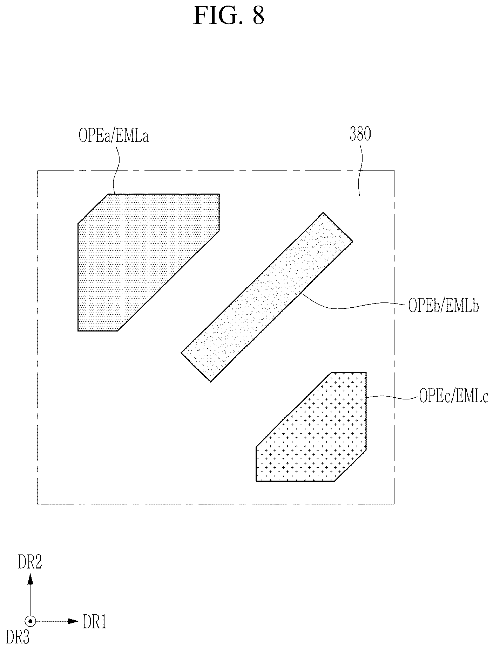

The embodiment of FIG. 8 is a variation of the embodiment of FIG. 4, such that the space for laser drilling is positioned on the lower left.

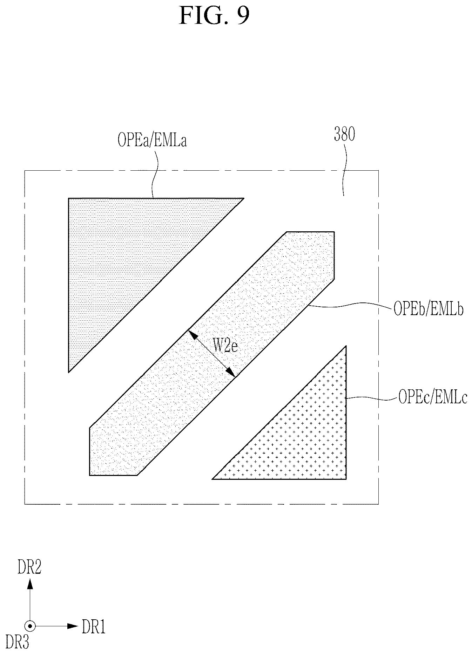

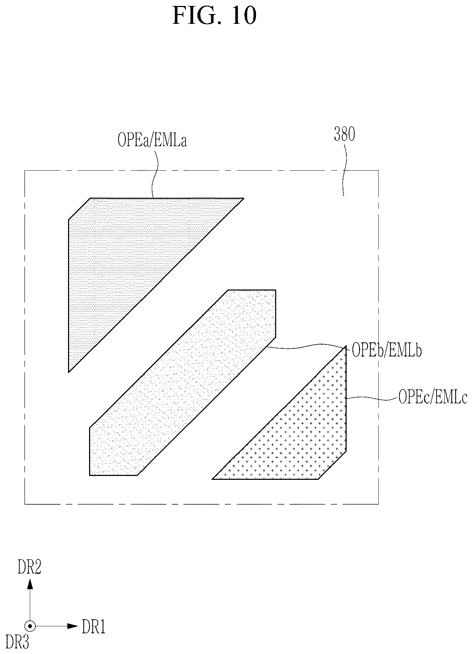

The embodiment of FIG. 9 is a variation of the embodiment of FIG. 5, and includes the first light emitting region OPEa and the third light emitting region OPEc having a triangle shape without chamfers. On the other hand, the embodiment of FIG. 9 may be modified to include the laser drilling region based on FIG. 4 or FIG. 8. In FIG. 10, similar to that illustrated in FIG. 4, the unit pixel area may secure the space for laser drilling on the upper right side.

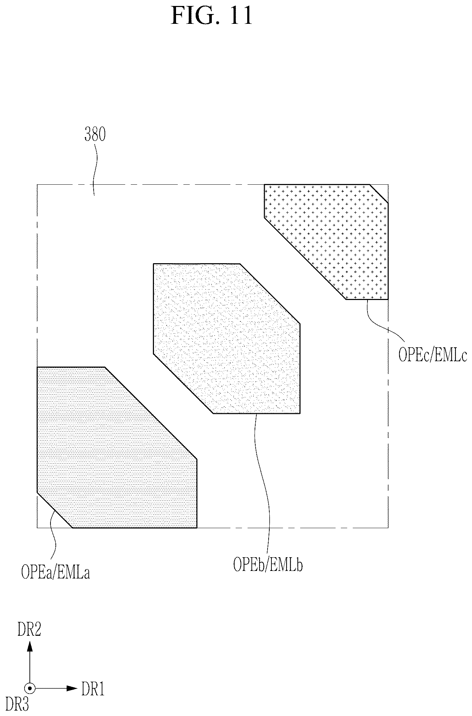

The embodiments of FIG. 11 to FIG. 13 form each light emitting region OPEa, OPEb, OPEc to be as large as possible within the unit pixel area, and are embodiments in which the boundary of the unit pixel area and the boundary of at least one of the light emitting regions OPEa, OPEb, and OPEc coincide with each other.

In the embodiment of FIG. 11, unlike the previous embodiments, each light emitting region OPEa, OPEb, OPEc is positioned along the second diagonal direction.

In more detail, referring to FIG. 11, each light emitting region OPEa, OPEb, and OPEc is disposed along the second diagonal direction. In this case, at least two from among the light emitting regions OPEa, OPEb, and OPEc are disposed while overlapping with each other in the first direction DR1 and/or the second direction DR2. The second diagonal direction is a direction that forms a suitable angel (e.g., a certain or predetermined angle) with respect to the first direction DR1 and the second direction DR2, and may be a direction that forms an angle of 45 degrees with respect to the first direction DR1 and the second direction DR2 according to an embodiment. The center of each light emitting region OPEa, OPEb, and OPEc may be disposed along the second diagonal direction. Here, the center of each light emitting region OPEa, OPEb, OPEc may mean a geometric mass center of each light emitting region OPEa, OPEb, OPEc, and may be a position corresponding to an arithmetic average of all points included in each light emitting region OPEa, OPEb, OPEc on a plane (e.g., in a plan view).

When the light emitting regions OPEa, OPEb, and OPEc are arranged along the second diagonal direction while overlapping with one another in the first direction DR1 and the second direction DR2, the discoloration phenomenon in which a specific color may be recognized at the boundary of the displayed image may be reduced.

In the embodiment of FIG. 11, the first light emitting region OPEa for displaying red is positioned on the leftmost side, the second light emitting region OPEb for displaying green is positioned on the right thereof, and the third light emitting region OPEc for displaying blue is positioned on the rightmost side. By arranging the colors as shown in FIG. 11 based on the first direction DR1, it may be possible to display a clearer font in which letters are not smeared and displayed neatly when the letters are displayed in a certain way. This display method may be similar to a display method of Microsoft Corporation.

The first light emitting region OPEa according to the embodiment of FIG. 11 has two sides (a first side and a second side) overlapping with sides of the unit pixel area shown as a dotted line. The ends of the first and second sides of the first light emitting region OPEa do not touch each other, and a side extending in the oblique direction is positioned therebetween. Here, the side extending in the oblique direction may be parallel to or substantially parallel to the first diagonal direction perpendicular to or substantially perpendicular to the second diagonal direction. The first light emitting region OPEa according to the embodiment of FIG. 11 may have a hexagonal shape, and may have a structure in which three corners of a triangle shape are chamfered or two corners of a quadrangle shape are chamfered, according to an embodiment. A part of each outer side of the first light emitting region OPEa may coincide with or be parallel to or substantially parallel to one side of the unit pixel area shown as a dotted line, and the other sides (e.g., the inner side) may be parallel to or substantially parallel to the first diagonal direction. Here, the first diagonal direction is a direction that forms a suitable angel (e.g., a certain or predetermined angle) with respect to the inverse direction of first direction DR1 and the second direction DR2, and may be a direction that forms an angle of 45 degrees with respect to the opposite direction of the first direction DR1 and the second direction DR2 according to an embodiment.

The third light emitting region OPEc according to the embodiment of FIG. 11 has two overlapping sides (a first side and a second side) with the sides of the unit pixel area shown as a dotted line, and is positioned on the opposite side of the second diagonal direction with respect to the first light emitting region OPEa. The third light emitting region OPEc includes the two sides (the first side and the second side) each corresponding to a side of the first direction DR1 or the second direction DR2 of the unit pixel area, and the ends of the first and the second sides of the third light emitting region OPEc do not touch each other, such that a side extending in the diagonal direction is positioned therebetween. The side extending in the oblique direction may be parallel to or substantially parallel to the first diagonal direction perpendicular to or substantially perpendicular to the second diagonal direction. The third light emitting region OPEc may have a hexagonal shape, and may have a structure in which three corners of a triangle shape are chamfered or two corners of a quadrangle shape are chamfered, according to an embodiment. A part of each outer side of the third light emitting region OPEc may be parallel to or substantially parallel to one side of the unit pixel area shown as a dotted line, and the other side (e.g., the inner side) may be parallel to or substantially parallel to the first diagonal direction.

The shape of the first light emitting region OPEa and the third light emitting region OPEc may be variously modified as needed or desired, but may have two sides that are parallel to or substantially parallel to sides of the first direction DR1 and the second direction DR2 of the unit pixel area, respectively, thereby having a shape corresponding to the pixel area.

The second light emitting region OPEb according to the embodiment of FIG. 11, unlike the first light emitting region OPEa and third the light emitting region OPEc, is disposed inside the unit pixel area not to overlap with the sides of the unit pixel area to be positioned relatively farther away (that is, relatively further away from the sides of the pixel unit than the first and second light emitting regions). The center of the unit pixel area may be positioned within the second light emitting region OPEb. The second light emitting region OPEb may have a hexagonal shape, and may have a structure in which three corners of a triangle shape are chamfered or two corners of a quadrangle shape are chamfered, according to an embodiment. A part of each outer side of the second light emitting region OPEb may be parallel to or substantially parallel to one side of the unit pixel area shown as a dotted line, and the other sides (e.g., the inner sides) may be parallel to or substantially parallel to the first diagonal direction perpendicular to or substantially perpendicular to the second diagonal direction.

In the embodiment of FIG. 11, each light emitting region OPEa, OPEb, and OPEc may be formed to have a suitable width (e.g., a certain or predetermined width) or more, and an emission layer may be formed by an inkjet method.

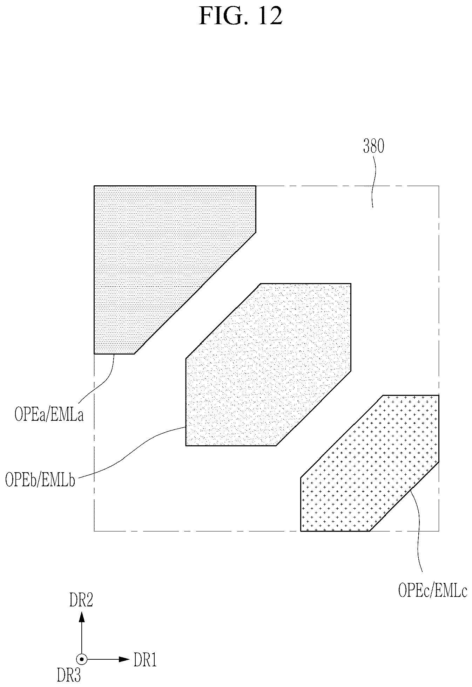

The embodiment of FIG. 12 illustrates a variation of the embodiment of FIG. 1. Unlike that of FIG. 1, each light emitting region OPEa, OPEb, and OPEc is enlarged within the unit pixel area, and at least one side of the first light emitting region OPEa and the third light emitting region OPEc has a structure overlapping with the boundary of the unit pixel area.

The shape of each light emitting region OPEa, OPEb, OPEc according to the embodiment of FIG. 12 is the same or substantially the same as that of FIG. 1, and thus, redundant description is not be repeated.

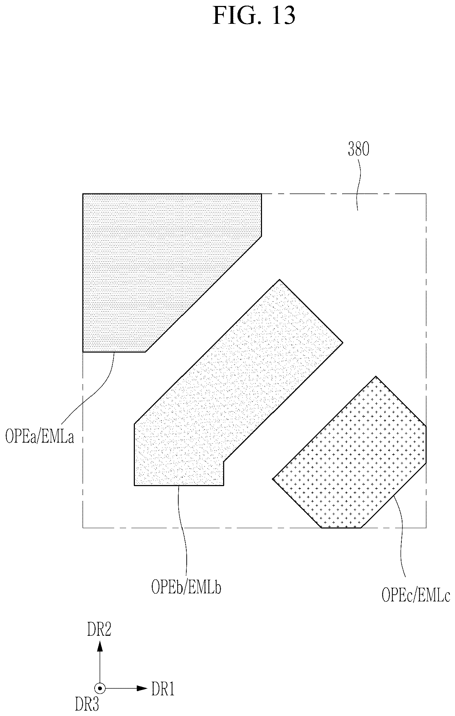

In the embodiment of FIG. 13, the shapes of the second light emitting region OPEb and the third light emitting region OPEc are different from those described above, and the second light emitting region OPEb is relatively smaller while including the laser drilling region compared to the embodiment of FIG. 12.

The structure of the second light emitting region OPEb and the third light emitting region OPEc of FIG. 13, which is different from those of the embodiment of FIG. 12, is described in more detail hereinafter.

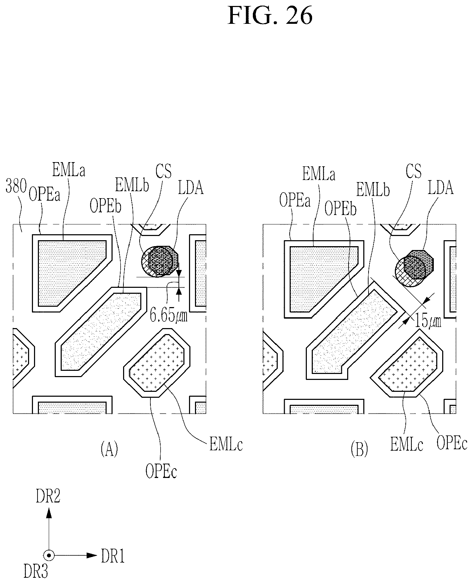

The second light emitting region OPEb of the embodiment of FIG. 13 has a quadrangle shaped portion, and extends in the second diagonal direction. In the upper right region, the second light emitting region OPEb is not positioned, and thus, the laser drilling region is formed. In the lower left region, the second light emitting region OPEb includes a protruded part that is bent to extend in the opposite direction of the second direction DR2. In order to compensate for the decrease in the size of the second light emitting region OPEb due to the laser drilling region positioned in the upper right region, the protruded part in the second direction DR2 is formed. Some sides of the second light emitting region OPEb may not be parallel to or substantially parallel to sides of the unit pixel area shown as a dotted line, and may be parallel to or substantially parallel to the first diagonal direction or the second diagonal direction. Referring to FIG. 26 (B), the second light emitting region OPEb according to the embodiment of FIG. 13 has a larger horizontal distance from the laser drilling region, and thus, even if a process error occurs, the effect on the second light emitting region OPEb may be small, and the area of the second light emitting region OPEb may be secured by the protruded part, so that the color component (e.g., green) displayed by the second light emitting region OPEb is not insufficient and the unit pixel may display a certain color. According to an embodiment, the protruded direction of the protruded part may correspond to the first direction DR1.

The third light emitting region OPEc according to the embodiment of FIG. 13 has two sides (a first side and a second side) overlapping with sides of the unit pixel area shown as a dotted line, and the ends of the first and second sides of the third light emitting region OPEc do not touch each other, such that a side extending in the oblique direction is positioned between them. Here, the side extending in the oblique direction may be parallel to or substantially parallel to the second diagonal direction perpendicular to or substantially perpendicular to the first diagonal direction, and the second diagnol direction is a direction in which each light emitting region OPEa, OPEb, OPEc extends. The third light emitting region OPEc may have a structure in which two corners of a quadrangle shape are chamfered, and each of the chamfered parts may coincide with one corresponding side of the unit pixel area. According to an embodiment, the third light emitting region OPEc may have a pentagonal shape (or hexagonal shape as shown). A part of each outer side of the third light emitting region OPEc may coincide with or be parallel to or substantially parallel to one side of the unit pixel area shown as a dotted line, and the other sides (e.g., the inner sides) may be parallel to or substantially parallel to the first diagonal direction or the second diagonal direction.

The shapes of the second light emitting region OPEb and the third light emitting region OPEc may be variously modified as needed or desired, but may have two sides that are parallel to or substantially parallel to sides of the first direction DR1 and the second direction DR2 of the unit pixel area, respectively, and may be positioned to be adjacent to the unit pixel area.

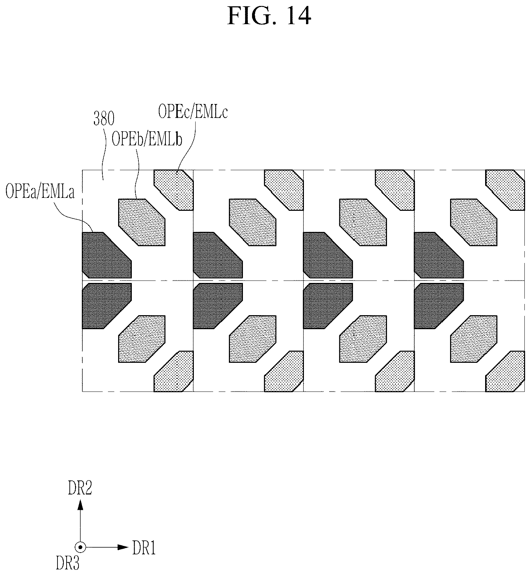

In the embodiment of FIG. 14, each light emitting region OPEa, OPEb, OPEc of two unit pixel areas positioned along the second direction DR2 is arranged along a chevron shape.

In more detail, in a first row, the unit pixels of the embodiment of FIG. 11 are positioned, and in a second row, the unit pixels of the embodiment of FIG. 12 are positioned. Each light emitting region OPEa, OPEb, OPEc of the embodiment of FIG. 11 is disposed along the second diagonal direction, and each light emitting region OPEa, OPEb, OPEc of the embodiment of FIG. 12 is disposed along the first diagonal direction, thereby, forming a chevron shape by the second diagonal direction and the first diagonal direction. The chevron shape of FIG. 14 may have an inequality sign (<) indicating that the right side is greater than the left side. The first diagonal direction and the second diagonal direction may each have an angle of 45 degrees with respect to the first direction DR1 and/or the second direction DR2, and the angle of the center of the chevron shape may be a right angle. However, this angle may be variously modified as needed or desired.

In more detail, based on FIG. 14, each light emitting region OPEa, OPEb, OPEc positioned in two rows is disposed along a chevron shape, and at least two of the light emitting regions OPEa, OPEb, OPEc are disposed while overlapping with each other in the first direction DR1 and/or the second direction DR2. The center of each light emitting region OPEa, OPEb, and OPEc may be disposed along the chevron shape. Here, the center of each light emitting region OPEa, OPEb, OPEc may mean a geometric mass center of each light emitting region OPEa, OPEb, OPEc, and may be a position corresponding to an arithmetic average of all points included in each light emitting region OPEa, OPEb, OPEc on a plane (e.g., in a plan view).

When they are arranged along the second diagonal direction while overlapping with one another in the first direction DR1 and the second direction DR2, the discoloration phenomenon in which a specific color may be recognized at the boundary of the displayed image may be reduced.

Also, in each unit pixel area in the embodiment of FIG. 14, the first light emitting region OPEa for displaying red is positioned on the leftmost side, the second light emitting region OPEb for displaying green is positioned on the right thereof, and the third light emitting region OPEc for displaying blue is positioned on the rightmost side. By displaying the colors in this order, it may be possible to display a clearer font in which letters are not smeared and displayed neatly when the letters are displayed in a certain way. This display method may be similar to a display method of Microsoft Corporation. Based on FIG. 14, the light emitting regions belonging to the different unit pixels and positioned adjacent to each other may display the same color.

On the other hand, according to an embodiment, each light emitting region OPEa, OPEb, OPEc positioned in two rows may be arranged in a chevron shape, but the arrangement of the colors may be variously modified differently from that of FIG. 14. For example, the light emitting regions belonging to different unit pixels and positioned adjacent to each other may display different colors.

Although various structures of the unit pixel are shown in FIG. 1, FIG. 2, FIG. 4, FIG. 5, and FIG. 7 to FIG. 14, the first light emitting region OPEa, the second light emitting region OPEb, and the third light emitting region OPEc thereof may be sequentially disposed along the first diagonal direction, the first light emitting region OPEa and the second light emitting region OPEb may be disposed to overlap with each other along the first direction DR1 or the second direction DR2, and the second light emitting region OPEb and the third light emitting region OPEc may be disposed to overlap with each other along the first direction DR1 or the second direction DR2. In addition, numerous variations other than the embodiments illustrated in the drawings may be possible. In other words, a different embodiment may be formed by merging the light emitting regions illustrated in the various drawings, and the plane shape of each light emitting region may also be variously modified as needed or desired.

The first light emitting region OPEa, the second light emitting region OPEb, and the third light emitting region OPEc may each have a planar shape of a polygon, such as a triangle or a quadrangle, and at least one of the edges of the polygon may have a chamfered structure.

Some of the sides of each of the first light emitting region OPEa, the second light emitting region OPEb, and the third light emitting region OPEc, may be parallel to or substantially parallel to the first direction DR1 or the second direction DR2, and the remaining sides may be parallel to or perpendicular to the first diagonal direction.

The first light emitting region OPEa, the second light emitting region OPEb, and the third light emitting region OPEc may correspond to the first opening, the second opening, and the third opening, respectively, of the pixel definition layer 380, and the first emission layer EMLa may be formed within the first opening, the second emission layer EMLb may be formed within the second opening, and the third emission layer EMLc may be formed within the third opening. The emission layers EMLa, EMLb, and EMLc may be formed within the first opening, second opening, and third opening, respectively, by the Inkjet method.

For each of the first light emitting region OPEa, the second light emitting region OPEb, and the third light emitting region OPEc, the geometric center of the planar shape thereof may be disposed along the first diagonal or the second diagonal direction.

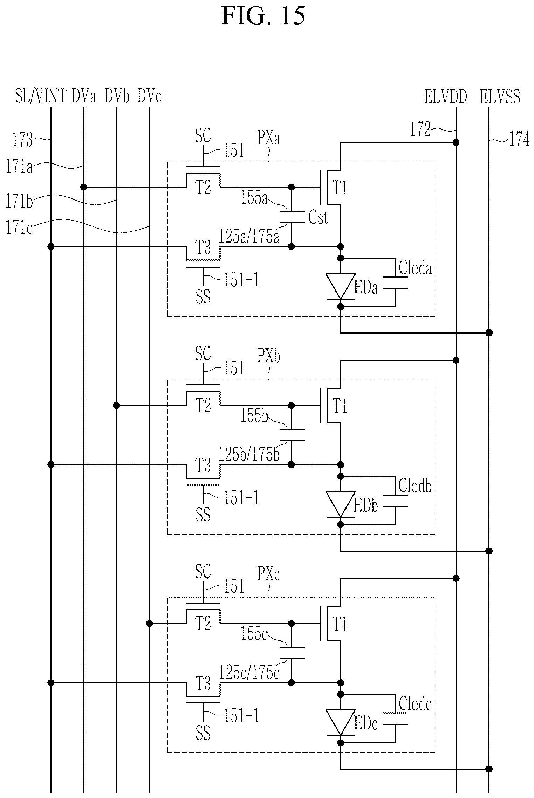

The circuit structure of the pixel included in the light emitting display device according to an embodiment is described in more detail hereinafter with reference to FIG. 15.

FIG. 15 is an equivalent circuit diagram of a pixel of a light emitting display device according to an embodiment.

FIG. 15 shows a circuit diagram of three pixels PXa, PXb, and PXc including a group of light emitting diodes (LEDs) EDa, EDb, EDc.

A plurality of pixels may include a first pixel PXa, a second pixel PXb, and a third pixel PXc. The first pixel PXa, the second pixel PXb, and the third pixel PXc includes a plurality of transistors T1, T2, and T3, a storage capacitor Cst, and a light emitting diode (LED) EDa, EDb, and EDc. Here, one pixel PXa, PXb, and PXc may be divided into a light emitting diode (LED) EDa, EDb, and EDc and a pixel circuit part, and the pixel circuit part may include the plurality of transistors T1, T2, and T3 and the storage capacitor Cst as illustrated in FIG. 15. In addition, according to an embodiment, a capacitor Cleda, Cledb, and Cledc (hereinafter referred to as a light emitting capacitor) connected to both terminals (e.g., opposite terminals) of the light emitting diode (LED) EDa, EDb, and EDc may be further included, and the light emitting capacitor Cleda, Cledb, and Cledc may not be included in the pixel circuit part and may be included in the light emitting diode (LED) EDa, EDb, and EDc.

The plurality of transistors T1, T2, and T3 include one driving transistor T1 (also referred to as a first transistor) and two switching transistors T2 and T3. The two switching transistors include an input transistor T2 (also referred to as a second transistor). Each transistor T1, T2, and T3 includes a gate electrode, a first electrode, and a second electrode, and also includes a semiconductor layer having a channel so that a current flows to or is blocked from the channel of the semiconductor layer depending on a voltage of the gate electrode. Here, one of the first and second electrodes may be a source electrode and the other may be a drain electrode depending on the voltage applied to each transistor T1, T2, and T3.

The gate electrode of the driving transistor T1 is connected to one terminal of the storage capacitor Cst, and is also connected to the second electrode (an output electrode) of the input transistor T2. Also, the first electrode of the driving transistor T1 is connected to a driving voltage line 172 for transmitting a driving voltage ELVDD. The second electrode of the driving transistor T1 is connected to the anode of the corresponding light emitting diode (LED) EDa, EDb, and EDc, the other terminal of the storage capacitor Cst, the first electrode of the third transistor T3, and one terminal of the corresponding light emitting capacitor Cleda, Cledb, and Cledc. The driving transistor T1 may receive a corresponding data voltage DVa, DVb, and DVc through the gate electrode depending on the switching of the input transistor T2, and may supply the driving current to the corresponding light emitting diode (LED) EDa, EDb, and EDc depending on the voltage of the gate electrode. At this time, the storage capacitor Cst stores and maintains the voltage of the gate electrode of the driving transistor T1.

The gate electrode of the input transistor T2 is connected to the first scan signal line 151 that transmits the first scan signal SC. The first electrode of the input transistor T2 is connected to the corresponding data line 171a, 171b, and 171c that transmits the corresponding data voltage DVa, DVb, and DVc, and the second electrode of the input transistor T2 is connected to one terminal of the storage capacitor Cst and the gate electrode of the driving transistor T1. A plurality of data lines 171a, 171b, and 171c transmit different data voltages DVa, DVb, and DVc, and the input transistors T2 of the pixels PXa, PXb, and PXc are connected to different data lines 171a, 171b, and 171c. The gate electrode of the input transistor T2 of each pixel PXa, PXb, and PXc is connected to the same first scan signal line 151 to receive the first scan signal SC at the same or substantially the same timing. Even if the input transistor T2 of each pixel PXa, PXb, and PXc is turned on concurrently or substantially simultaneously with each other by the first scan signal SC at the same or substantially the same timing, the different data voltages DVa, DVb, and DVc are transmitted to the gate electrodes of driving transistors T1 and one terminal of the storage capacitors Cst of the pixels PXa, PXb, and PXc through the different data lines 171a, 171b, and 171c.

The embodiment of FIG. 15 illustrates that the gate electrode of the initialization transistor T3 receives a different scan signal from that of the gate electrode of the input transistor T2.

The gate electrode of the initialization transistor T3 is connected to a second scan signal line 151-1 that transmits the second scan signal SS. The first electrode of the initialization transistor T3 is connected to the other terminal of the storage capacitor Cst, the second electrode of the driving transistor T1, the anode of the corresponding light emitting diode (LED) EDa, EDb, and EDc, and one terminal of the corresponding light emitting capacitor Cleda, Cledb, and Cledc. The second electrode of the initialization transistor T3 is connected to an initialization voltage line 173 for transmitting the initialization voltage VINT. The initialization transistor T3 is turned on depending on the second scan signal SS to transmit the initialization voltage VINT to the anode of the corresponding light emitting diode (LED) EDa, EDb, and EDc, one terminal of the corresponding light emitting capacitor Cleda, Cledb, and Cledc, and the other terminal of the storage capacitor Cst, thereby, initializing the voltage of the anode of the corresponding light emitting diode (LED) EDa, EDb, and EDc.

The initialization voltage line 173 may perform an operation to sense the voltage of the anode of the corresponding light emitting diode (LED) EDa, EDb, and EDc before applying the initialization voltage VINT, thereby, serving as a sensing wire SL. Through the sensing operation, it may be possible to check whether or not the voltage of the anode is maintained as a target voltage. The sensing operation and the initialization operation that transmits the initialization voltage VINT may be performed in a temporal division, and the initialization operation may be performed after the sensing operation is performed.

In the embodiment of FIG. 15, a turn-on section of the initialization transistor T3 and the input transistor T2 may be distinguished, so that the writing operation performed by the input transistor T2 and the initialization operation (and/or the sensing operation) performed by the initialization transistor T3 may be performed at different timings.

According to an embodiment, the second scan signal line 151-1 may be omitted, and the first scan signal line 151 for transmitting the first scan signal SC may be modified, so that the gate electrode of the initialization transistor T3 and the first scan signal line 151 are connected to each other.

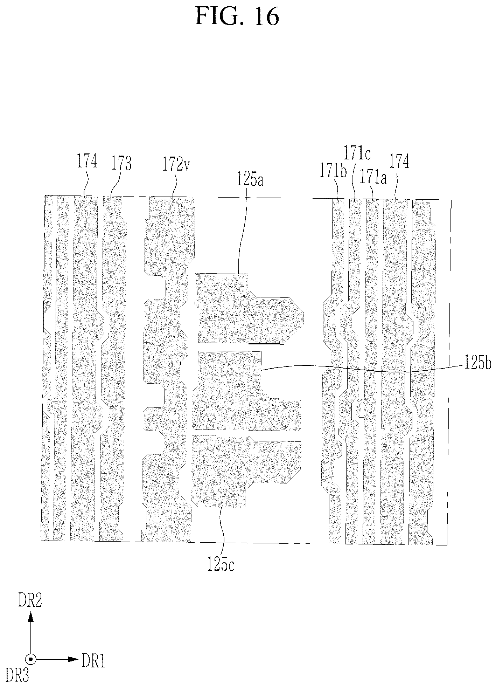

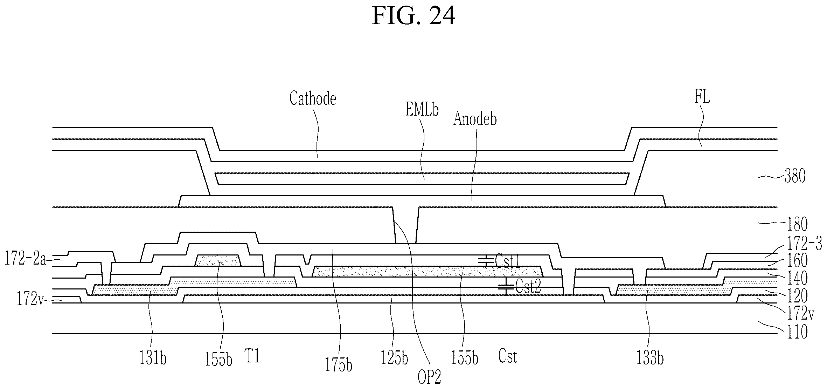

One terminal of the storage capacitor Cst is connected to the gate electrode of the driving transistor T1 and the second electrode of the input transistor T2. The other terminal of the storage capacitor Cst is connected to the first electrode of the initialization transistor T3, the second electrode of the driving transistor T1, the anode of the corresponding light emitting diode (LED) EDa, EDb, and EDc, and one terminal of the corresponding light emitting capacitor Cleda, Cledb, and Cledc. In FIG. 15, the reference numerals are shown on one terminal and the other terminal of the storage capacitor Cst, in which it is shown to clearly indicate whether any part corresponds to the storage capacitor Cst in FIG 16 and/or the like. One terminal of the storage capacitor Cst is integrally formed with the corresponding gate electrode 155a, 155b, and 155c of the driving transistor T1, and the other terminal of the storage capacitor Cst is disposed on the corresponding lower storage electrode 125a, 125b, and 125c and the corresponding upper storage electrode 175a, 175b, and 175c. Referring to FIG. 24, in the cross-sectional structure of the storage capacitor Cst, the lower storage electrodes 125a, 125b, and 125c are positioned at the bottom, the gate electrodes 155a, 155b, and 155c of the driving transistor T1 are disposed thereon to be insulated therefrom, and the upper storage electrodes 175a, 175b, and 175c are disposed thereon to be insulated therefrom. Insulating layers 120, 140, and 160 positioned between these three layers serve as dielectric layers, and the lower storage electrodes 125a, 125b, and 125c and the upper storage electrodes 175a, 175b, and 175c are electrically connected to each other, and thus, may have the same voltage as each other.

The cathode of the light emitting diodes (LED) EDa, EDb, and EDc receives the driving low voltage ELVSS through a driving low voltage line 174. The light emitting diodes (LED) EDa, EDb, and EDc emit light depending on the output current of the corresponding driving transistor T1, thereby, displaying a gray (e.g., a grayscale level).

In addition, the light emitting capacitors Cleda, Cledb, and Cledc are formed at both ends (e.g., opposite ends) of the light emitting diodes (LED) EDa, EDb, and EDc, so that the voltage at both ends of the light emitting diodes (LED) EDa, EDb, and EDc may be kept constant, and then, the light emitting diodes (LED) EDa, EDb, and EDc may display a constant luminance.

Hereinafter, an operation of the pixel having the same circuit as that illustrated in FIG. 15 is described in more detail.

FIG. 15 illustrates an embodiment in which each transistor T1, T2, and T3 is an N-type transistor, so that the transistor turns on when a high-level voltage is applied to the gate electrode thereof. However, according to another embodiment, each transistor T1, T2, and T3 may be a P-type transistor.

One frame begins when a light emission section ends. Next, the second scan signal SS of a high level is supplied, and the initialization transistor T3 is turned on. When the initialization transistor T3 is turned on, the initialization operation and/or the sensing operation may be performed.

An embodiment in which both the initialization operation and the sensing operation are performed is described as follows.

The sensing operation may be performed first before the initialization operation is performed. In other words, as the initialization transistor T3 is turned on, the initialization voltage line 173 performs the role of the sensing wiring SL to detect the voltage of the anode of the light emitting diodes (LED) EDa, EDb, and EDc. Through the sensing operation, it may be possible to check whether or not the voltage of the anode is maintained at the target voltage.

Next, the initialization operation may be performed so as to change the voltage of the other terminal of the storage capacitor Cst, the second electrode of the driving transistor T1, and the anode of the light emitting diodes (LED) EDa, EDb, and EDc into the initialization voltage VINT transferred from the initialization voltage line 173, thereby, performing the initialization.

The sensing operation and the initialization operation of transmitting the initialization voltage VINT are performed with a temporal division, so that the pixel may perform the various operations while reducing the area occupied by the pixel by using a minimum or reduced number of transistors. As a result, the resolution of the display panel may be improved.

Along with the initialization operation or the first scan signal SC applied at separate timings while being changed into a high level, the input transistor T2 is turned on and the writing operation is performed. In other words, though the turned-on input transistor T2, the data voltages DVa, DVb, and DVc from the data lines 171a, 171b, and 171c is input to the gate electrode of the driving transistor T1 and one terminal of the storage capacitor Cst, and is stored.

The data voltages DVa, DVb, and DVc and the initialization voltage VINT are applied to both ends of the storage capacitor Cst by the initialization operation and the writing operation. In the state that the initialization transistor T3 is turned on, even if the output current is generated from the driving transistor T1, it may be externally output through the initialization transistor T3 and the initialization voltage line 173, so the output current may not be input to the light emitting diodes (LED) EDa, EDb, and EDc. Also, according to an embodiment, during the writing section in which the first scan signal SC of a high level is supplied, by applying the driving voltage ELVDD as the voltage of a low level or the driving low voltage ELVSS as the voltage of a high level, the current may not flow to the light emitting diodes (LED) EDa, EDb, and EDc.

Next, when the first scan signal SC is changed into a low level, the driving transistor T1 generates and outputs the output current by the driving voltage ELVDD of a high level applied to the driving transistor T1 and the gate voltage of the driving transistor T1 stored in the storage capacitor Cst. The output current of the driving transistor T1 is input to the light emitting diodes (LED) EDa, EDb, and EDc, so that the light emission section in which the light emitting diodes (LED) EDa, EDb, and EDc emit light is performed.

A more detailed structure of the pixel circuit unit from among the pixels PXa, PXb, and PXc having the same circuit structure as that of FIG. 15 is described hereinafter with reference to FIG. 16 to FIG. 25.

The detailed structure of the pixel circuit unit among the pixels PXa, PXb, and PXc having the same circuit structure as that of FIG. 1 is described with reference to FIG. 16 to FIG. 25.

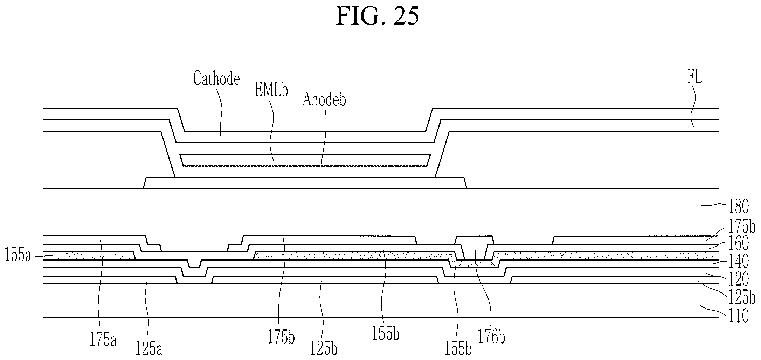

FIG. 16 through FIG. 23 are top plan views showing a manufacturing order of a display area of a light emitting display device according to an embodiment. FIG. 24 and FIG. 25 are cross-sectional views of a light emitting display device according to embodiments.

FIG. 24 and FIG. 25 mainly shows the cross-sectional structure of the second pixel PXb, and show the cross-sectional structures of different parts of the second pixel PXb.

In FIG. 24 and FIG. 25, from the substrate 110 to the planarization film 180, a plurality of transistors T1, T2, and T3 and the storage capacitor Cst are formed from among the pixels, which is also called a driving element layer, and the light emitting diodes (LED) EDa, EDb, and EDc are formed on the planarization film 180 and is also referred to as a light-emitting element layer.

Hereinafter, a description will be made with reference to a cross-sectional view, while focusing on a plan view.

Referring to FIG. 24 and FIG. 25, the light emitting display device according to an embodiment may include a substrate 110. The substrate 110 may include a material that does not bend due to a rigid characteristic such as glass, or a flexible material that may be bent such as plastic or polyimide. In the case of the flexible substrate, it may have a double-layered structure of polyimide, and a barrier layer formed of an inorganic insulating material thereon is formed double.

Referring FIG. 16, on the substrate 110, a lower conductive layer including lower storage electrodes 125a, 125b, and 125c, data lines 171a, 171b, and 171c, a first driving voltage line 172v, an initialization voltage line 173, and a driving low voltage line 174 is formed.

The lower storage electrodes 125a, 125b, and 125c are formed in an island shape. The lower storage electrodes 125a, 125b, and 125c serve as one electrode of the corresponding storage capacitor Cst.

The data lines 171a, 171b, and 171c are extended to the second direction DR2, and are connected to the pixels PXa, PXb, and PXc to transmit data voltages DVa, DVb, and DVc to the pixels PXa, PXb, and PXc, respectively.

The first driving voltage line 172v, the initialization voltage line 173, and the driving low voltage line 174 are each extended to the second direction DR2, and respectively transmit a driving voltage ELVDD, an initialization voltage VINT, and a driving low voltage ELVSS.

The lower conductive layer may include at least one of various suitable metals, such as copper (Cu), aluminum (Al), magnesium (Mg), silver (Ag), gold (Au), platinum (Pt), palladium (Pd), nickel (Ni), neodymium Nd, iridium (Ir) ), molybdenum (Mo), tungsten (W), titanium (Ti), chromium (Cr), tantalum (Ta), or suitable alloys thereof. In addition, the lower conductive layer may be formed of a single layer or multiple layers.

The lower conductive layer is covered by a buffer layer (e.g., see Fig. 24, 120). The buffer layer 120 serves to block a penetration of impurity elements into the semiconductor layer, and may be an inorganic insulating layer including silicon oxide (SiOx), silicon nitride (SiNx), or silicon oxynitride (SiONx).

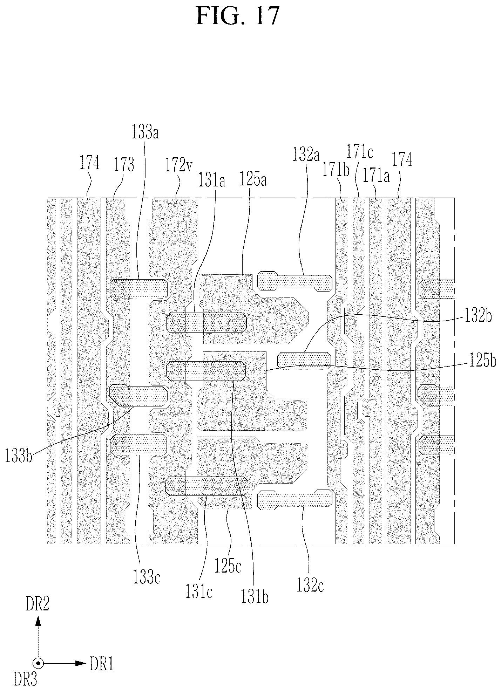

Referring to FIG. 17, a semiconductor layer formed of a silicon semiconductor (e.g., polycrystalline semiconductor (P-Si)) or an oxide semiconductor is positioned on the buffer layer 120. The semiconductor layer includes the semiconductor of the driving transistor T1 (131a, 131b, 131c; hereinafter referred to as a first semiconductor), the semiconductor of the input transistor T2 (132a, 132b, 132c; hereinafter referred to as a second semiconductor), and the semiconductor of the initialization transistor T3 (133a, 133b, 133c; hereinafter referred to as a third semiconductor).

The semiconductor layer is covered with a gate insulating layer (referring to 140 of FIG. 24). The gate insulating layer 140 may be an inorganic insulating layer including silicon oxide (SiOx), silicon nitride (SiNx), or silicon oxynitride (SiONx).

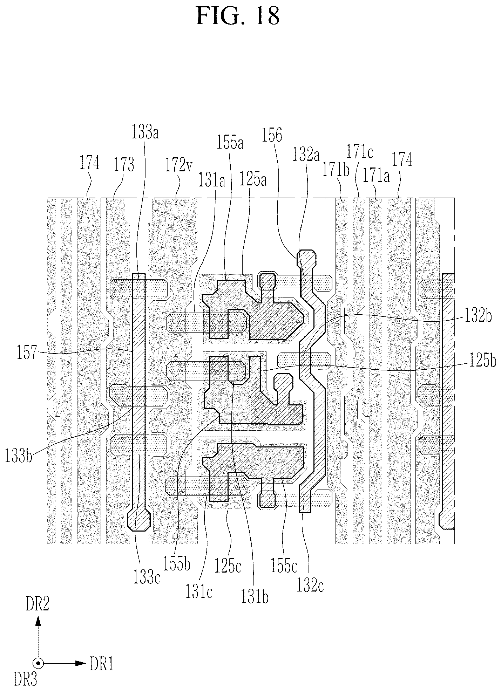

Referring to FIG. 18, a first gate conductive layer is formed on the gate insulating layer 140.

The first gate conductive layer includes first gate electrodes 155a, 155b, and 155c of the driving transistor T1, second gate electrodes 156 of the input transistor T2, and a third gate electrode 157 of the initialization transistor T3.

Each of the first gate electrode 155a, 155b, and 155c of the driving transistor T1 may be divided into a part (hereinafter, referred to as a second storage electrode part) overlapping with each lower storage electrode 125a, 125b, and 125c, a part (hereinafter, also referred to as a first gate electrode part) protruded from the upper storage electrode part and crossing the middle of the first semiconductor 131a, 131b, and 131c, and a part (hereinafter, referring to as a second semiconductor connection part) that is protruded toward the second semiconductor 132a, 132b, and 132c on a plane (e.g., in a plan view) from the upper storage electrode part or overlaps with one end of the second semiconductor 132a, 132b, and 132c.

The second gate electrode 156 and the third gate electrode 157 are extended in the second direction DR2. The second gate electrode 156 is positioned crossing the middle of the second semiconductors 132a, 132b, and 132c in the second direction DR2, and the third gate electrode 157 is positioned crossing the middle of the third semiconductors 133a, 133b, and 133c in the second direction DR2.

The first gate conductive layer may include a metal or a metal alloy, such as aluminum (Al), copper (Cu), molybdenum (Mo), or titanium (Ti), and may be composed of a single layer or multiple layers.

The first gate conductive layer is covered by an interlayer insulating layer (referring to 160 of FIG.160). The interlayer insulating layer 160 may include an inorganic insulating layer including silicon oxide (SiOx), silicon nitride (SiNx), silicon oxynitride (SiONx), or the like, and according to an embodiment, an inorganic insulating material may be formed to be thick. Also, according to an embodiment, the interlayer insulating layer 160 may be formed of an organic insulator, and may include at least one material selected from the group consisting of polyimide, polyamide, acryl resin, benzocyclobutene, and phenol resin.

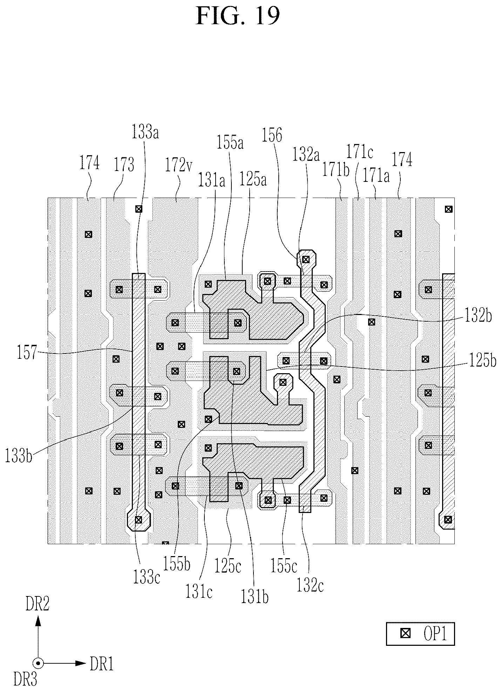

Referring to FIG. 19, an opening OP1 is formed on at least one of the interlayer insulating layer 160, the gate insulating layer 140, or the buffer layer 120 to expose a portion of the lower conductive layer, the semiconductor layer, and the first gate conductive layer positioned thereunder.

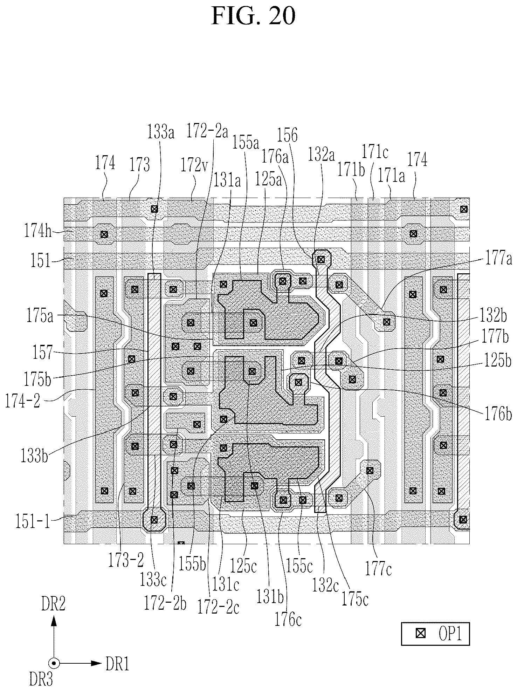

Referring to FIG. 20, a first data conductive layer is formed on the interlayer insulating layer 160.

The first data conductive layer may include a first scan signal line 151, a second scan signal line 151-1, and a second driving low voltage line 174h extending in the first direction DR1, and may further include a plurality of connecting electrodes 172-2a, 172-2b, 172-2c, 173-2, 174-2, 176a, 176b, 176c, 177a, 177b, 177c, and an upper storage electrode 175a, 175b, and 175c.

The first scan signal line 151 extends to the first direction DR1, and is electrically connected to one end of the second gate electrode 156 through the opening OP1. The second scan signal line 151-1 also extends to the first direction DR1, and is electrically connected to one end of the third gate electrode 157 through the opening OP1.

The second driving low voltage line 174h is connected to the driving low voltage line 174 through the opening OP1, and transfers the driving low voltage ELVSS to the first direction DR1 and the second direction DR2 together with the driving low voltage line 174, so that the voltage level of the driving low voltage ELVSS does not decrease in each pixel. On the other hand, the connecting electrode 174-2 is connected to the driving low voltage line 174 through the opening OP1, and overlaps with a part of the driving low voltage line 174.

The connecting electrode 172-2a and 172-2c is connected to one end of the first semiconductors 131a, 131b, and 131c and a part of the first driving voltage line 172v through the opening OP1, so that the driving voltage ELVDD is transmitted to one end of the semiconductor 131a, 131b, and 131c. On the other hand, the connecting electrode 172-2b is connected only to a part of the first driving voltage line 172v through the opening OP1. According to an embodiment, the connecting electrode 172-2b may also be connected to one of the first semiconductors 131a, 131b, and 131c or may be omitted as needed or desired.

The connecting electrode 173-2 is connected to a portion of the initialization voltage line 173 and one end of the third semiconductor 133a, 133b, and 133c through the opening OP1, so that the initialization voltage VINT is transmitted to one end of the third semiconductor 133a, 133b, and 133c.

The connecting electrodes 176a, 176b, and 176c are connected to one end of the first gate electrodes 155a, 155b, and 155c and one end of the second semiconductor 132a, 132b, and 132c through the opening OP1 to connect the gate electrode of the driving transistor T1 and the second electrode of the input transistor T2 to each other.

Connecting electrodes 177a, 177b, and 177c are connected to a part of the data line 171a, 171b, and 171c and the other end of second semiconductor 132a, 132b, and 132c through the opening OP1, so that the data voltage DVa, DVb, and DVc is transmitted to the first electrode of the input transistor T2.

The upper storage electrodes 175a, 175b, and 175c are formed in an island shape, and are electrically connected to the other ends of the first semiconductors 131a, 131b, and 131c and a part of the lower storage electrodes 125a, 125b, and 125c through the opening OP1. In addition, it is extended and electrically connected to the other end of the third semiconductors 133a, 133b, and 133c through the opening OP1. As a result, the lower storage electrodes 125a, 125b, and 125c and the upper storage electrodes 175a, 175b, and 175c have the same voltage level as each other, and together, serve as the second storage electrode of the storage capacitor Cst. The upper storage electrode 175a, 175b, and 175c overlaps with the second storage electrode part of the first gate electrodes 155a, 155b, and 155c on a plane (e.g., in a plan view), thereby, constituting the storage capacitor Cst. In addition, it is connected to the driving transistor T1 so that the output current of the driving transistor T1 may be transmitted, and it is connected to the initialization transistor T3 so that the initialization voltage VINT may be transmitted or the voltages of the upper storage electrode 175a, 175b, and 175c may be sensed. Because the upper storage electrodes 175a, 175b, and 175c are connected to the anodes Anodea, Anodeb, and Anodec of the light emitting diodes (LED) EDa, EDb, and EDc in a subsequent process, the voltage of the upper storage electrodes 175a, 175b, and 175c may be the same as that of the anodes Anodea, Anodeb, and Anodec of the light emitting diodes (LED) EDa, EDb, and EDc.

The first data conductive layer may include a metal or a metal alloy, such as aluminum (Al), copper (Cu), molybdenum (Mo), titanium (Ti), and/or the like, and may be composed of a single layer or multiple layers.

The first data conductive layer is covered by a planarization layer (referring to 180 of FIG. 24). The planarization layer 180 may be formed of an organic insulator, and may include at least one material selected from the group consisting of polyimide, polyamide, acryl resin, benzocyclobutene, and phenol resin.

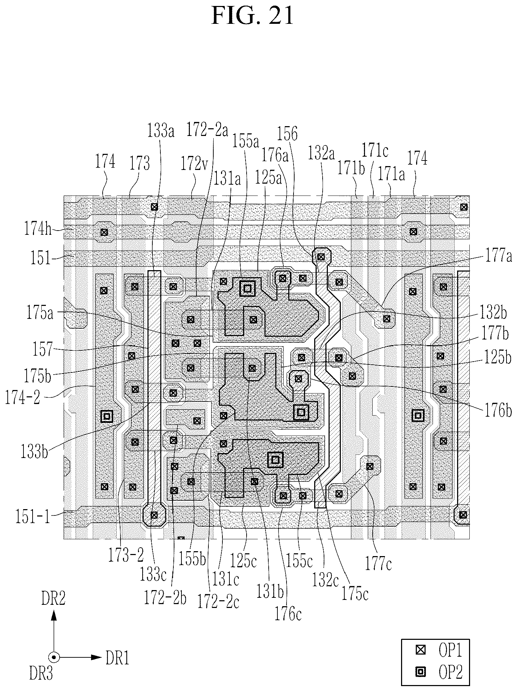

Referring to FIG. 21, the planarization layer 180 includes an opening OP2. The opening OP2 exposes a portion of the upper storage electrodes 175a, 175b, and 175c and a portion of the connecting electrode 174-2.

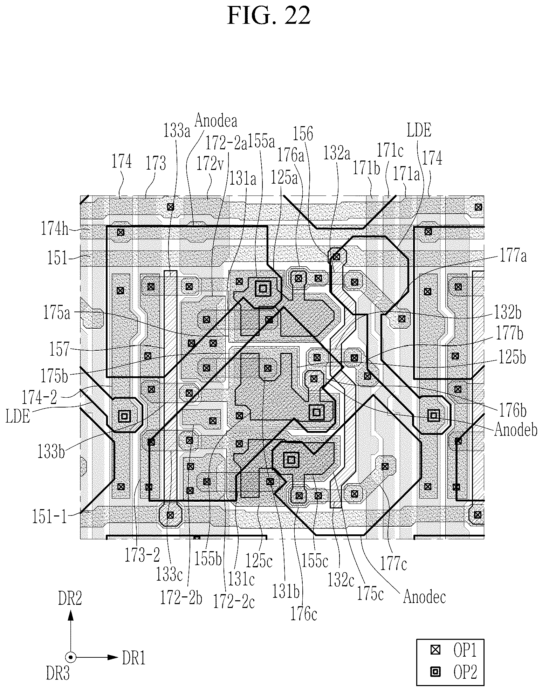

Referring to FIG. 22, on the planarization layer 180, an anode conductive layer including the anodes Anodea, Anodeb, and Anodec, and a laser drilling connecting electrode LDE is positioned.

The anodes Anodea, Anodeb, and Anodec are connected to the upper storage electrodes 175a, 175b, and 175c through the opening OP2, respectively, and receive the output current of the driving transistor T1.

The laser drilling connecting electrode LDE is divided into an expanded part and an elongated part extending from the expanded part, and the end of the elongated part is electrically connected to the connecting electrode 174-2 through the opening OP2. Because a driving low voltage ELVSS is applied to the connecting electrode 174-2, the driving low voltage ELVSS is also transmitted to the laser drilling connecting electrode LDE.

The anode conductive layer may be composed of a single layer including a transparent conductive oxide film or a metal material, or multi-layers including the same. The transparent conductive oxide layer may include indium tin oxide (ITO), poly-ITO, indium zinc oxide (IZO), indium gallium zinc oxide (IGZO), and/or indium tin zinc oxide (ITZO). The metal material may include silver (Ag), molybdenum (Mo), copper (Cu), gold (Au), and/or aluminum (Al).

The anode conductive layer is covered by a pixel definition layer (referring to 380 of FIG. 24).

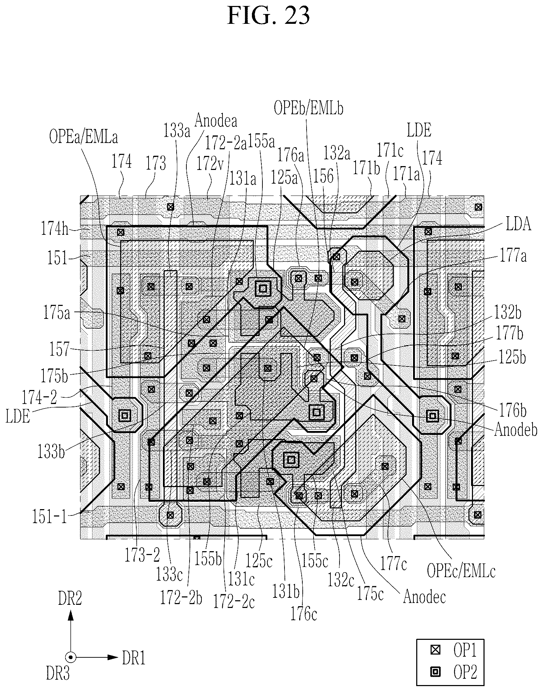

Referring to FIG. 23, the pixel definition layer 380 includes openings OPEa, OPEb, and OPEc, and the portions of the anodes Anodea, Anodeb, and Anodec are exposed by the openings. An emission layer EMLa, EMLb, and EMLc may be positioned on the exposed anodes Anodea, Anodeb, and Anodec. The emission layers EMLa, EMLb, and EMLc may be positioned (e.g., may only be positioned) within the openings OPEa, OPEb, and OPEc of the pixel definition layer 380.

The pixel definition layer 380 may be an organic insulator including at least one material selected from the group consisting of polyimide, polyamide, acryl resin, benzocyclobutene, and phenol resin. According to an embodiment, the pixel definition layer 380 may be formed of a black pixel definition layer (BPDL) including a black color pigment.

The planar shapes of the openings OPEa, OPEb, and OPEc of each pixel definition layer 380 shown in FIG. 23 correspond to the shape of the openings OPEa, OPEb, and OPEc in FIG. 26 (B), respectively, and are descried in more detail below with reference to FIG. 26(B).

Referring to FIG. 24 and FIG. 25, a cathode Cathode is formed on the pixel definition layer 380 and the emission layer EMLa, EMLb, and EMLc. A functional layer FL may be positioned between the anode Anodea, Anodeb, and Anodec, and the emission layer EMLa, EMLb, and EMLc, and between the emission layer EMLa, EMLb, and EMLc, and the cathode Cathode.

The emission layers EMLa, EMLb, and EMLc may be positioned within the pixel openings OPEa, OPEb, and OPEc delimited by the pixel definition layer 380. The emission layers EMLa, EMLb, and EMLc may include an organic material for emitting red, green, and blue. The emission layers EMLa, EMLb, and EMLc for emitting red, green, and blue may include low-molecular or high-molecular organic materials.

The functional layer FL positioned above and below the emission layers EMLa, EMLb, and EMLc may be divided into a first functional layer positioned between the anodes Anodea, Anodeb, and Anodec and the emission layers EMLa, EMLb, and EMLc, and a second functional layer positioned above the emission layers EMLa, EMLb, and EMLc. The first functional layer may include a hole injection layer and/or hole transport layer, and the second functional layer may include an electron transport layer and/or electron injection layer. The functional layer FL and the emission layer EML may be combined to be referred to as an intermediate layer. The functional layer FL is also formed above the pixel definition layer 380 and within the openings OPEa, OPEb, and OPEc.

Above the functional layer FL, a cathode Cathode is formed above the pixel definition layer 380 and the openings OPEa, OPEb, and OPEc.

The anodes Anodea, Anodeb, and Anodec, the emission layers EMLa, EMLb, and EMLc, and the cathode cathode constitute light-emitting elements, and the light-emitting elements may further include the functional layer FL.

The current transmitted to the anode Anodea, Anodeb, and Anodec passes through the first functional layer, the emission layer EMLa, EMLb, and EMLc, and the second functional layer, respectively, and is transmitted to the cathode Cathode. At this time, the emission layer EML emits light due to the current flowing through the emission layers EMLa, EMLb, and EMLc, and the light-emitting element represents a luminance.

Laser is irradiated to the laser drilling region LDA, and the cathode Cathode penetrates the pixel definition layer 380. The laser drilling connecting electrode LDE and the cathode Cathode are electrically shorted. As a result, the driving low voltage ELVSS is transmitted to the cathode Cathode.

The cathode Cathode may be formed of a transparent conductive layer including ITO (Indium Tin Oxide), IZO (Indium Zinc Oxide), IGZO (Indium Gallium Zinc Oxide), and/or ITZO (Indium Tin Zinc Oxide). In addition, the cathode Cathode may have a translucent characteristic, and in this case, may form a micro-cavity together with the anodes Anodea, Anodeb, and Anodec. According to the micro-cavity structure, light with a desired wavelength (e.g., a specific or predetermined wavelength) is emitted upwards by a gap and characteristics between both electrodes, and as a result, red, green, or blue may be displayed.

In FIG. 24 and FIG. 25, an encapsulation layer may be further positioned on the cathode. The encapsulation layer includes at least one inorganic layer and at least one organic layer, and may have a triple layered structure including a first inorganic encapsulation layer, an organic encapsulation layer, and a second inorganic encapsulation layer. The encapsulation layer may be for protecting the emission layers EMLa, EMLb, and EMLc from moisture or oxygen that may inflow from the outside. According to an embodiment, the encapsulation layer may include a structure in which an inorganic layer and an organic layer are sequentially stacked.

According to an embodiment, a sensing insulating layer and a plurality of sensing electrodes may be positioned on the encapsulation layer for touch sensing.

According to an embodiment, a film including a polarizer may be attached on the encapsulation layer to reduce a reflection of external light. In addition, a color filter or a color conversion layer may be further formed to improve color quality, and in this case, the polarizer may not be attached. A light blocking layer may be positioned between the color filter or the color conversion layer. In addition, according to an embodiment, a layer formed with a suitable material (hereinafter, referred to as a reflection control material) capable of absorbing some wavelengths of external light may be further included, and in this case, the polarizer may not be attached. Also, according to an embodiment, the front surface of the light emitting display device may be covered with an additional organic layer (also referred to as a planarization layer) to be flattened or substantially flattened.

Because the cross-sectional structure of FIG. 24 and FIG. 25 is provided as example embodiments, numerous variations thereto may be possible.

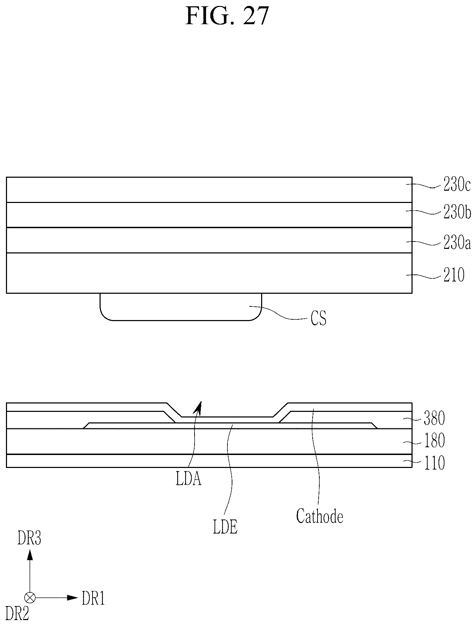

In FIG. 24 and FIG. 25, although the structure above the cathode Cathode is not shown, the structure above the cathode Cathode according to an embodiment in the light emitting display device including the laser drilling region LDA is described in more detail with reference to FIG. 26 and FIG. 27.

FIG. 26 is a top plan view showing a part of a light emitting display device according to an embodiment. FIG. 27 is a cross-sectional view of a light emitting display device according to the embodiment of FIG. 26.

FIG. 26 illustrates two embodiments, each including a laser drilling region LDA positioned in the unit pixel area, and a spacer CS is formed in the region overlapping with the laser drilling region LDA on a plane (e.g., in a plan view). The embodiments of FIG. 26 (A) and (B) have different second light emitting regions OPEb from each other, and the first light emitting regions OPEa are the same or substantially the same as each other, and the third light emitting regions OPEc have almost the same shapes (e.g., similar shapes) as each other.

In FIG. 26, the boundaries of each light emitting region OPEa, OPEb, and OPEc) and the boundaries of the emission layers EMLa, EMLb, and EMLc of each light-emitting element are separately shown. The emission layers EMLa, EMLb, and EMLc of each light-emitting element are positioned within each corresponding light emitting region OPEa, OPEb, and OPEc, which is the opening of the pixel definition layer 380, but they are not filled as a whole, and it is shown that the boundary of the emission layers EMLa, EMLb, and EMLc of the light-emitting element may be positioned on the inner side compared to the boundary of each light emitting region OPEa, OPEb, and OPEc, which is the opening of the pixel definition layer 380.

In more detail, the planar structure of each light emitting region OPEa, OPEb, and OPEc is described as follows.

First, in the embodiment of FIG. 26 (A), the first light emitting region OPEa has the same planar structure as that of the first light emitting region OPEa of the embodiments of FIG. 1 and FIG. 2. The second light emitting region OPEb has the structure similar to that of the second light emitting region OPEb of the embodiment of FIG. 2, and has a structure that is not partially formed on the upper right side as the laser drilling region is positioned on the upper right side of the unit pixel area. The second light emitting region OPEb has a hexagonal shape. The third light emitting region OPEc has a hexagonal shape or a structure that at least two edges are chamfered in a quadrangle shape. The embodiment of FIG. 26 (A) has a similar structure to that of the embodiment of FIG. 10.

On the other hand, in the embodiment of FIG. 26 (B), the first light emitting region OPEa has the same planar structure as that of the first light emitting region OPEa of the embodiments of FIG. 1 and FIG. 2. The second light emitting region OPEb has the same planar structure as that of the second light emitting region OPEb of FIG. 13. The third light emitting region OPEc has a hexagonal shape or a structure in which two corners of a quadrangle shape are chamfered.

As shown in FIG. 26 (A) and (B), the horizontal distance between the spacer CS and the second light emitting region OPEb or the opening of the pixel definition layer may be different depending on the shape of the second light emitting region OPEb adjacent to the laser drilling region LDA.

In the embodiment of FIG. 26 (A), the horizontal spacing is illustrated as 6.65 µm, and in the embodiment of FIG. 26 (B), the horizontal spacing is illustrated as 15 µm. It may be confirmed that the embodiment of FIG. 26 (B) may have more than twice the horizontal spacing compared to the embodiment of FIG. 26 (A). Considering the process error in the embodiment of FIG. 26 (B), the horizontal interval between the spacer CS and the second light emitting region OPEb or the opening of the pixel definition layer may have a value of 10 µm or more and 18 µm or less.

This horizontal spacing ensures that the spacer CS does not cover the light emitting region even if it is misaligned, thereby, securing a process margin, as the interval from the laser drilling region LDA is also large, it may be confirmed that the second light emitting region OPEb is also less affected by the process error that occurs during the laser drilling.

Also, in the embodiment of FIG. 26 (B), on the lower left side of the second light emitting region OPEb, the second light emitting region OPEb includes a protruded part that is bent in the opposite direction of the second direction DR2. In order to compensate for the reduction in the size of the second light emitting region OPEb due to the laser drilling region positioned in the upper right region, the protruded part in the second direction DR2 is further included, and then the area of the second light emitting region OPEb may be also be secured by the protruded part, so that the color component (e.g., green) displayed by the second light emitting region OPEb is not insufficient and the unit pixel may display a constant color.

Referring to FIG. 26 (B), when one side of the second light emitting region OPEb adjacent to the spacer CS or the laser drilling region LDA is formed in the direction perpendicular to or substantially perpendicular to the direction from the second light emitting region OPEb toward the spacer CS or the laser drilling region LDA, it may be confirmed that the sufficient margin may be secured.

FIG. 27 shows the cross-sectional structure of the light emitting display device according to the embodiments of FIG. 26 (A) and FIG. 26 (B). In the embodiment of FIG. 27, a light blocking layer positioned in the region (including the laser drilling region LDA) excluding each light emitting region OPEa, OPEb, and OPEc by stacking three color filters 230a, 230b, and 230c is shown. However, according to an embodiment, a light blocking layer having a separate black color may be formed in the region (including the laser drilling region LDA) excluding each light emitting region OPEa, OPEb, and OPEc.

In more detail, the light emitting display device may include the lower panel including a plurality of unit pixels, and the upper panel positioned on the lower panel and including the spacer. Here, the lower panel may include the components from the substrate 110 to the cathode Cathode as shown in FIG. 24 and FIG. 25. The upper panel, as shown in FIG. 27, may include the encapsulation substrate 210, the color filter 230a, 230b, and 230c, and the spacer CS. The color filters 230a, 230b, and 230c may be positioned on the upper side of the encapsulation substrate 210, or in other words, in the third direction DR3, and the spacer CS may be positioned on the lower side of the encapsulation substrate 210, or in other words, in an opposite direction of the third direction DR3.

Each of the color filters 230a, 230b, and 230c of three colors overlaps with each light emitting region OPEa, OPEb, and OPEc to impart color components to light emitted from the light emitting regions OPEa, OPEb, and OPEc or to enhance color components.

FIG. 27 shows that the spacer CS is positioned at the lower part based on the encapsulation substrate 210, and the color filters 230a, 230b, and 230c are formed at the upper part.

The spacer CS may be formed at a position overlapping at least partially with the laser drilling region LDA, and maintains a certain distance from the lower panel where the encapsulation substrate 210 and the light-emitting element are formed.

FIG. 27 shows a structure in which the laser drilling region LDA is formed on the opening positioned in the pixel definition layer 380, and the cathode Cathode and the underlying laser drilling connecting electrode LDE are electrically connected. However, this is to express that the cathode Cathode and the laser drilling connecting electrode LDE are electrically connected to each other, and may differ from the cross-sectional shape in which the actual laser is irradiated. In other words, when the laser is irradiated, the cathode Cathode and the pixel definition layer 380 of the irradiated region are melted, and the cathode Cathode and the laser drilling connecting electrode LDE are electrically connected to each other. At this time, the laser drilling connecting electrode LDE may also partially melt.

The encapsulation substrate 210 is attached to the lower panel through a sealant along the exterior side, and may be formed so that moisture or air from the outside does not flow into the inside.

According to an embodiment, a film or a flattening layer may be further included on the color filters 230a, 230b, and 230c.

Referring to FIG. 25 and FIG. 26, at least part of the spacer CS is positioned to overlap with the laser drilling region LDA on a plane (e.g., in a plan view). When formed in this way, the region for forming the spacer CS and the region for the laser drilling need not be separately formed, and thus, the area of the non-display area from among the display areas may be reduced.

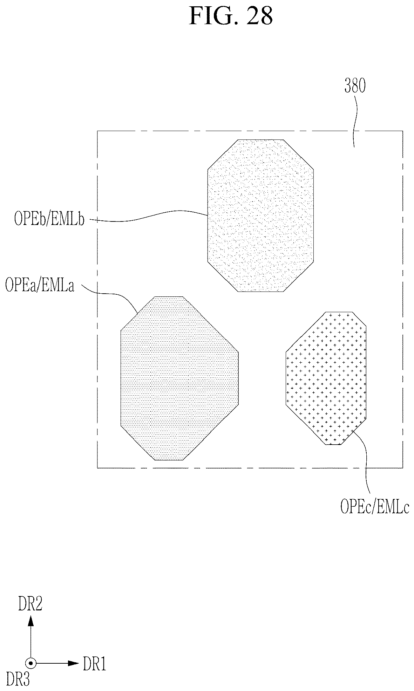

In the following, based on a comparative example illustrated in FIG.28, aperture ratio characteristics of the present embodiment are also examined.

First, a flat structure of the comparative example is described in more detail with reference to FIG. 28.

FIG. 28 is a schematic top plan view of a display area of a light emitting display device according to a comparative example.

In the present embodiment, each light emitting region OPEa, OPEb, and OPEc is disposed along the first diagonal direction, and at least two of the light emitting regions OPEa, OPEb, and OPEc are arranged to overlap with each other in the first direction DR1 and/or the second direction DR2.

In contrast, in the comparative example of FIG. 28, at least two of the light emitting regions OPEa, OPEb, and OPEc overlap with each other in the first direction DR1 or the second direction DR2, but they are not disposed along the diagonal direction.

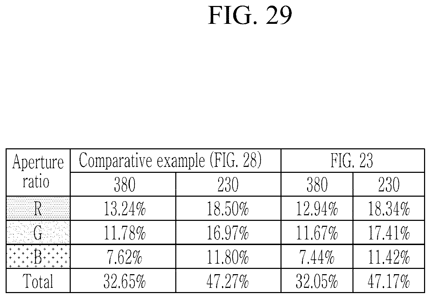

Hereinafter, with reference to FIG. 29, values of the aperture ratios between the comparative example of FIG. 28 and the embodiment of FIG. 23 (or the embodiment of FIG. 26 (B)) are compared and described in more detail.

FIG. 29 is a table comparing the aperture ratios of a comparative example and an embodiment.

In FIG. 29, each aperture ratio in a pixel definition layer 380 and a color filter 230 is numerically displayed along with a classification of red (R), green (G), and blue (B).

Referring to FIG. 29, it may be seen that there is a small difference in the aperture ratio values in the pixel definition layer 380 and/or the color filter 230 between the comparative example (FIG. 28) and the embodiment of FIG. 23. Therefore, the embodiment of FIG. 23 has almost the same aperture ratio as that of the comparative example of FIG. 28, and it may be confirmed that the same level of light as that of the comparative example of FIG. 28 may be emitted. Therefore, because the present embodiment may also secure the sufficient aperture ratio corresponding to the comparative example, problems such as luminance deterioration and an efficiency reduction, which may occur due to the insufficient aperture ratio, may be avoided, and the display quality suitable for the light emitting display device may be provided.

On the other hand, as the comparative example of FIG. 28 is similar to the Comparative Example 1 described above with reference to FIG. 6, it may have a discoloration index like the discoloration index of the Comparative Example 1 of FIG. 6.

There may be a problem that the discoloration index on the upper and lower sides exceeds 5, and the user may easily recognize the discoloration phenomenon. On the other hand, in the embodiment of FIG. 23, the discoloration phenomenon may not be recognized.

The foregoing is illustrative of some embodiments of the present disclosure, and is not to be construed as limiting thereof. Although some embodiments have been described, those skilled in the art will readily appreciate that various modifications are possible in the embodiments without departing from the scope of the present disclosure. It will be understood that descriptions of features or aspects within each embodiment should typically be considered as available for other similar features or aspects in other embodiments, unless otherwise described. Thus, as would be apparent to one of ordinary skill in the art, features, characteristics, and/or elements described in connection with a particular embodiment may be used singly or in combination with features, characteristics, and/or elements described in connection with other embodiments unless otherwise specifically indicated. Therefore, it is to be understood that the foregoing is illustrative of various example embodiments and is not to be construed as limited to the specific embodiments disclosed herein, and that various modifications to the disclosed embodiments, as well as other example embodiments, are intended to be included within the scope of the present disclosure as defined in the appended claims.

### Description of symbols

OPEa, OPEb, OPEc: light emitting region, opening of pixel definition layer
EML, EMLa, EMLb, EMLc: emission layer
380: pixel definition layer
Anodea, Anodeb, Anodec: anode
Cathode: cathode
FL: functional layer
LDA: laser drilling region
LDE: drilling connecting electrode
CS: spacer
T1, T2, T3: transistor
171a, 171b, 171c: data line
172, 172v: driving voltage line
173: initialization voltage line
174, 174h: driving low voltage line
151: first scan signal line
151-1: second scan signal line
SL: sensing wiring
Cst: storage capacitor
EDa, EDb, EDc: light emitting diode (LED)
Cleda, Cledb, Cledc: light emitting capacitor
PXa, PXb, PXc: pixel
110: substrate
120, 140, 180: insulating layer
125a, 125b, 125c: lower storage electrode
131a, 131b, 131c: first semiconductor
132a, 132b, 132c: second semiconductor
133a, 133b, 133c: third semiconductor
155a, 155b, 155c: first gate electrode
156: second gate electrode
157: third gate electrode
175a, 175b, 175c: upper storage electrode
   OP1, OP2: opening
210: encapsulation substrate
230, 230a, 230b, 230c: color filter
172-2a, 172-2b, 172-2c, 173-2, 174-2, 176a, 176b, 176c, 177a, 177b, 177c: connecting electrode

## Claims

1. A light emitting display device comprising:
a plurality of unit pixels, each comprising a first light emitting region, a second light emitting region, and a third light emitting region,
wherein, in a unit pixel from among the plurality of unit pixels:
the first light emitting region, the second light emitting region, and the third light emitting region are sequentially located along a first diagonal direction having an angle with respect to first and second directions;
the first light emitting region and the second light emitting region overlap with each other in the first direction or the second direction; and
the second light emitting region and the third light emitting region overlap with each other in the first direction or the second direction.

2. The light emitting display device of claim 1, wherein the first light emitting region, the second light emitting region, and the third light emitting region have a flat shape of a polygon, optionally a triangle or a quadrangle.

3. The light emitting display device of claim 2, wherein at least one of edges of the polygon of the first light emitting region, the second light emitting region, and the third light emitting region has a chamfered structure.

4. The light emitting display device of claim 2 or 3, wherein some sides of the first light emitting region, the second light emitting region, and the third light emitting region is parallel to the first direction or the second direction, and other sides are parallel to or perpendicular to the first diagonal direction.

5. The light emitting display device of claim 2, 3, or 4, wherein:
the plurality of unit pixels comprises first unit pixels located in a first row, and second unit pixels located in a second row directly below the first row;
the first light emitting region, the second light emitting region, and the third light emitting region of the first unit pixels are sequentially located along the first diagonal direction; and
the first light emitting region, the second light emitting region, and the third light emitting region of the second unit pixels are sequentially located along a second diagonal direction different from the first diagonal direction, optionally, wherein the second diagonal direction is perpendicular to the first diagonal direction.

6. The light emitting display device of any one of claims 1 to 5, wherein:
at least one of the unit pixels further comprises a laser drilling region; and
the second light emitting region included in the at least one of the unit pixels including the laser drilling region is shorter than the second light emitting region of another adjacent unit pixel.

7. The light emitting display device of claim 6, wherein the second light emitting region included in the at least one of the unit pixels including the laser drilling region extends in a second diagonal direction perpendicular to the first diagonal direction, and comprises a protruded part protruding in the first direction or the second direction.

8. The light emitting display device of any one of claims 1 to 7, wherein:
the first light emitting region, the second light emitting region, and the third light emitting region correspond to a first opening, a second opening, and a third opening of a pixel definition layer, respectively;
a first emission layer is within the first opening, a second emission layer is within the second opening, and a third emission layer is within the third opening; and
the first emission layer, the second emission layer, and the third emission layer are located in the first opening, the second opening, and the third opening, respectively, by an inkjet method.

9. The light emitting display device of any one of claims 1 to 8, wherein the first light emitting region, the second light emitting region, and the third light emitting region comprise a red light emitting region, a green light emitting region, and a blue light emitting region, respectively.

10. The light emitting display device of any one of claims 1 to 9, wherein a geometric center of each planar shape of the first light emitting region, the second light emitting region, and the third light emitting region is located along the first diagonal direction.

11. The light emitting display device as claimed in any one of claims 1 to 10, and comprising a lower panel comprising a plurality of unit pixels; and
an upper panel on the lower panel, and comprising a spacer,
wherein at least one unit pixel from among the plurality of unit pixels comprises:
a first light emitting region, a second light emitting region, a third light emitting region, and a laser drilling region; and
the laser drilling region and the spacer overlap at least partially with each other in a plan view.

12. A light emitting display device comprising:
a lower panel comprising a plurality of unit pixels; and
an upper panel on the lower panel, and comprising a spacer,
wherein at least one unit pixel from among the plurality of unit pixels comprises:
a first light emitting region, a second light emitting region, a third light emitting region, and a laser drilling region; and
the laser drilling region and the spacer overlap at least partially with each other in a plan view.

13. The light emitting display device of claim 11 or 12, wherein the upper panel further comprises:
an encapsulation substrate; and
a first color filter, a second color filter, and a third color filter on the encapsulation substrate, and
wherein the spacer is under the encapsulation substrate, optionally, wherein the spacer overlaps with the first color filter, the second color filter, and the third color filter in a plan view.

14. The light emitting display device of claim 13, wherein:
the first light emitting region, the second light emitting region, and the third light emitting region are sequentially located along a first diagonal direction having an angle with respect to first and second directions;
the first light emitting region and the second light emitting region overlap with each other in the first direction or the second direction; and
the second light emitting region and the third light emitting region overlap with each other in the first direction or the second direction.

15. The light emitting display device of claim 11 or 14, wherein the second light emitting region extends in a second diagonal direction perpendicular to the first diagonal direction, and comprises a protruded part protruding in the first direction or the second direction.

16. The light emitting display device of any one of claims 11 to 15, wherein the second light emitting region has a horizontal spacing of 10 µm or more and 18 µm or less from the spacer in a plan view.

17. The light emitting display device of claim 11 to 16, wherein:
the first light emitting region, the second light emitting region, and the third light emitting region correspond to a first opening, a second opening, and a third opening of a pixel definition layer, respectively;
a first emission layer is within the first opening, a second emission layer is within the second opening, and a third emission layer is within the third opening; and
the first light emitting region, the second light emitting region, and the third light emitting region may comprise a red light emitting region, a green light emitting region, and a blue light emitting region, respectively.

18. The light emitting display device of any one of claims claim 12 to 17, wherein the first light emitting region, the second light emitting region, and the third light emitting region comprise a red light emitting region, a green light emitting region, and a blue light emitting region, respectively.

19. The light emitting display device of any one of claims 11 to 18, wherein some sides of the first light emitting region, the second light emitting region, and the third light emitting region are parallel to the first direction or the second direction, and other sides are parallel to or perpendicular to the first diagonal direction.
